(19) Europäisches Patentamt
European Patent Office
Office européen des brevets

(11) **EP 2 340 545 B1**

(12) **FASCICULE DE BREVET EUROPEEN**

(45) Date de publication et mention
de la délivrance du brevet:
**30.08.2017 Bulletin 2017/35**

(21) Numéro de dépôt: **09783353.7**

(22) Date de dépôt: **24.09.2009**

(51) Int Cl.:
*H01G 7/02* *(2006.01)*   *H01G 5/16* *(2006.01)*
*H01G 5/38* *(2006.01)*   *H01H 13/00* *(2006.01)*
*H01L 41/083* *(2006.01)*   *H01L 41/047* *(2006.01)*
*H01L 41/09* *(2006.01)*   *H01L 41/113* *(2006.01)*
*H01L 41/27* *(2013.01)*   *H01L 41/29* *(2013.01)*
*H01L 41/297* *(2013.01)*

(86) Numéro de dépôt international:
**PCT/EP2009/062357**

(87) Numéro de publication internationale:
**WO 2010/034764 (01.04.2010 Gazette 2010/13)**

(54) **SYSTÈME À CAPACITÉ VARIABLE À DIÉLECTRIQUE SOUPLE**

SYSTEM MIT VARIABLER KAPAZITÄT UND FLEXIBLEM DIELEKTRIKUM

SYSTEM WITH VARIABE CAPACITY AND FLEXIBLE DIELECTRIC

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**

(30) Priorité: **25.09.2008 FR 0856460**

(43) Date de publication de la demande:
**06.07.2011 Bulletin 2011/27**

(73) Titulaire: **Commissariat à l'Énergie Atomique et aux Énergies Alternatives
75015 Paris (FR)**

(72) Inventeur: **DESPESSE, Ghislain
38120 Saint-Egreve (FR)**

(74) Mandataire: **Ilgart, Jean-Christophe et al
BREVALEX
95, rue d'Amsterdam
75378 Paris Cedex 8 (FR)**

(56) Documents cités:
EP-A- 1 686 599       WO-A-01/67810
WO-A-03/079384       CN-A- 1 547 312
US-A- 4 041 446       US-A- 5 677 965
US-A1- 2004 007 877   US-A1- 2004 207 369
US-A1- 2008 048 521

• PEANO FABIO , TAMBOSSO TIZIANA: "Design and optimization of a MEMS Electret-based capacitive energy scavenger" JOURNAL OF MICROMECHANICAL SYSTEMS, vol. 14, no. 3, juin 2003 (2003-06), pages 429-435, XP002523269

**EP 2 340 545 B1**

**Description**

**DOMAINE TECHNIQUE ET ART ANTÉRIEUR**

La présente invention se rapporte aux dispositifs à capacité variable utilisés pour la récupération d'énergie ou comme actionneurs par application d'une tension à leurs bornes, plus particulièrement aux dispositifs à capacité variable polarisés par un ou plusieurs électret(s).

Dans le domaine de la récupération d'énergie, il est connu d'utiliser des systèmes à capacité variable comportant au moins une électrode fixe, et au moins une électrode mobile en regard, les électrodes étant séparées par un entrefer d'air. L'électrode mobile est mise en mouvement par les vibrations extérieures et par injection et retrait d'une charge dans le système à des moments précis, il est possible de convertir l'énergie vibratoire en énergie électrique.

Des systèmes utilisant un entrefer formé d'un polymère déformable sont également connus, par exemple du document « Dielectric polymer: scavenging energy from human motion », de Claire Jean-Mistral, Skandar Basrour, Jean-Jacques Chaillout, dans « Electroactive Polymer Actuators and Devices » (EAPAD) 2008 edited by Bar-Cohen, Yoseph, Proceedings of the SPIE, Volume 6927, pp. 692716-1-692716-10 (2008). Ces systèmes nécessitent également une polarisation de la structure à chaque cycle pour réaliser des cycles de récupération d'énergie. Cette polarisation nécessite des moyens électroniques pour le transfert des charges électriques vers la structure électrostatique, de disposer toujours d'une énergie minimale et de faire une détection de la capacité maximale. Ceci engendre des pertes électriques importantes, et rend le système très complexe.

Il est également connu d'utiliser des électrets pour polariser les électrodes. Dans ce cas, il n'est plus nécessaire de polariser la structure à chaque cycle ; la gestion de l'injection et du retrait des charges n'est alors plus requise. Pour rappel, un électret est un matériau isolant électrique dans lequel sont stockées des charges électriques, soit des électrons, soit des ions. Un électret permet d'imposer une polarisation, cependant il ne permet pas de conduire le courant.

Des systèmes de récupération d'énergie mettant en oeuvre des électrets sont connus. Par exemple, le document « Efficiency Evaluation of Micro Seismic Electret Power Generator », de T. Tsutsumino, Y. Suzuki, N. Kasagi, K. Kashiwagi, Y. Morizawa dans "Proceedings of the 23rd Sensor Symposium", 2006, Takamatsu, pp. 521-524. La structure décrite dans ce document comporte un électret déposé sur une électrode de base et formant avec cette électrode, un condensateur à capacité fixe, et une électrode mobile séparée de l'électret par une couche d'air, celle-ci formant avec l'électret un condensateur à capacité variable. L'électrode mobile se déplace parallèlement à l'électret. La variation de la capacité du condensateur formé par l'électrode mobile et l'électret est obtenue par variation des surfaces en regard.

En fonction de la position de l'électrode mobile, une redistribution des charges électrique se fait entre l'électrode de base et l'électrode mobile via une résistance de charge entre l'électrode de base et l'électrode mobile.

D'autres systèmes de récupération d'énergie à capacité variable utilisant un électret sont également connus des documents « An Electret-based Electrostatic µ-generator » T. Sterken, P. Fiorini, K. Baert, R. Puers, G. Borghs,), TRANSDUCERS '03, The 12th International Conference on Solid State Sensors, Actuators and Microsystems, Boston, June 8-12, 2003, 0-7803-7731-1/03/\$17.00 ©2003 IEEE 1291, pages 1291-1294, et « Harvesting Energy from Vibrations by a Micormachined Electret Generator », T. Sterken, P. Fiorini, G. Altena, C. Van Hoof and R. Puers, 1-4244-0842-3/07/\$20.00©2007 IEEE, pages 129-132.

Le document WO 01/67810 décrit un autre système à capacité variable.

Or il est souhaitable de pouvoir réaliser des systèmes à capacité variable à entrefer en matériau diélectrique déformable, dans lesquels les problèmes liés à la polarisation ne se posent pas.

C'est par conséquent un but de la présente invention d'offrir un système à capacité variable comportant un entrefer en matériau déformable élastiquement, de conception simplifiée par rapport aux systèmes existants.

**EXPOSÉ DE L'INVENTION**

Le but précédemment énoncé est atteint par un système comportant au moins deux électrodes séparées par matériau diélectrique, au moins l'une des électrodes comportant au moins deux portions aptes à se rapprocher et à s'éloigner l'une de l'autre, un électret étant disposé dans l'espace entre ces portions. L'électret forme avec la première électrode un premier condensateur à capacité variable et l'électret et la deuxième électrode forme un deuxième condensateur à capacité variable.

En d'autres termes, on réalise un système à conversion d'énergie mécanique-électrique ou électrique-mécanique par déformation de ses électrodes, le système comportant au moins deux condensateurs à capacité variable, chacun polarisé par un électret, les capacités des condensateurs variant en sens inverse lorsque le système est déformé. Ainsi lorsque la capacité de l'un augmente, la capacité de l'autre diminue. Cette variation contraire de capacités provoque un transfert de charge entre les électrodes et la génération d'énergie électrique.

L'un des modes de réalisation comporte une structure ajourée apte à se déformer élastiquement dans son plan, l'électret étant disposé dans les fenêtres ainsi formées. Grâce à la mise en oeuvre d'au moins une électrode ajourée, il est possible d'obtenir sur un même diélectrique une variation en sens inverse des capacités, ce qui provoque une variation de la charge de chacune des électrodes et donc l'apparition d'un courant entre les électrodes.

On peut prévoir de réaliser une des électrodes avec un fil enroulé sous forme d'hélice, le fil entourant ou étant entouré par le diélectrique et l'électret étant entre deux spire du fil.

De manière particulièrement avantageuse, les deux électrodes sont ajourées, ce qui permet d'augmenter la quantité d'énergie électrique récupérée, ou les deux électrodes sont sous forme de fil enroulé en forme d'hélice.

La présente invention a alors principalement pour objet un système à capacité variable comportant une première électrode, une deuxième électrode, une couche en matériau diélectrique déformable élastiquement, ladite couche diélectrique étant disposée entre la première et la deuxième électrode, un premier électret formant avec la première électrode un premier condensateur, et le premier électret formant avec la deuxième électrode un deuxième condensateur, les capacités des premier et deuxième condensateur variant avec une déformation de la couche diélectrique, la première électrode, la deuxième électrode et le premier électret étant tels qu'ils suivent les déformations de la couche diélectrique et qu'une déformation de la couche diélectrique provoque une variation en sens opposé des capacités du premier et du deuxième condensateur, la première électrode comportant au moins deux portions aptes à se rapprocher et à s'éloigner l'une de l'autre, ledit électret étant disposé entre lesdites deux portions de la première électrode, les bords des portions formant avec le premier électret le premier condensateur, ledit premier électret étant sur ou dans la couche diélectrique.

Dans un mode de réalisation, au moins la première électrode étant munie d'au moins une lumière dans laquelle est situé le premier électret, le bord de ladite lumière formant avec le premier électret situé dans ladite lumière le premier condensateur, ledit premier électret étant sur ou dans la couche diélectrique.

Dans un autre mode de réalisation, le système à capacité variable a une forme cylindrique d'axe longitudinal et dans lequel la première électrode est formée par un fil conducteur électrique enroulé d'axe longitudinal formant une succession de spires, le premier électret étant situé entre deux spires successives.

La deuxième électrode peut être une couche sensiblement pleine et est recouverte de la couche diélectrique, la première électrode recouvrant la couche électrique sur une face opposée à celle en contact avec la deuxième électrode.

En variante, la deuxième électrode peut formée par un fil conducteur électrique enroulé d'axe longitudinal formant une succession de spires, un deuxième électret étant disposé entre au moins deux spires successives, les spires des première et deuxième électrodes étant décalées de sorte que les premier et deuxième électrets ne soient pas alignés selon une direction radiale.

Dans une autre variante de réalisation, la deuxième électrode comporte également au moins une lumière dans laquelle est disposé un deuxième électret de charge opposée au premier électret, de sorte que la deuxième électrode forme avec le deuxième électret un quatrième condensateur à capacité variable, et la première électrode forme avec le deuxième électret un cinquième condensateur à capacité variable, les capacités des premier et quatrième condensateurs variant dans le même sens, et les capacités des deuxième et cinquième condensateur variant dans le même sens avec la déformation de la couche diélectrique.

Par exemple, le premier et/ou le deuxième électret peut (peuvent) être disposé(s) sensiblement au centre de ladite lumière de manière sensiblement ponctuelle ou au centre de la zone délimitée par deux spires successives de manière sensiblement ponctuelle. Cette réalisation est particulièrement avantageuse dans le cas d'un électret rigide.

Dans une variante, le premier électret et/ou le deuxième électret remplit (remplissent) la lumière et est (sont) en contact avec les bords de ladite lumière, ou le premier électret et/ ou le deuxième électret remplit (remplissent) la zone délimitée par les deux spires successives, et est (sont) en contact avec lesdites spires.

Dans une autre variante, le premier électret et/ou le deuxième électret peut (peuvent) être formé(s) par ionisation de la couche diélectrique délimitée par la lumière, par exemple par procédé corona. Cette réalisation évite un dépôt supplémentaire sur la couche diélectrique.

Dans une variante, le premier électret et/ou le deuxième électret est (sont) sous la forme d'une poudre déposée sur la couche diélectrique.

A titre d'exemple, la couche diélectrique est en polymère, par exemple de type VHB®, avantageusement en VHB F9460, VHB F9469, VHB F9473, VHB4905® ou encore en VHB4910®, et les première et deuxième électrodes sont réalisées par exemple en cuivre, en argent, en graisse d'argent, en poudre de carbone, en or ou en polymère conducteur.

De manière avantageuse, la première et/ou la deuxième électrode(s) a (ont) des structures telles qu'elle(s) est (sont) déformable(s) élastiquement.

La première électrode et/ou la deuxième électrode peut (peuvent) alors être formée(s) par un ensemble de barreaux interconnectés de sorte à former un treillis délimitant plusieurs lumières, dans chacune desquelles le premier électret et/ou le deuxième électret est (sont) situés.

Le treillis peut être tel qu'une déformation du treillis dans une direction de son plan ne provoque peu ou pas de déformation dans une autre direction contenue dans le plan. Par exemple, les barreaux forment des sapins disposés côte à côte connectés électriquement par les extrémités de leurs branches, ou les barreaux forment des rangées de chevrons parallèles, lesdites rangées étant électriquement interconnectées par des barreaux d'interconnexions s'étendant entre deux rangées successives.

Le treillis peut également être tel qu'une déformation du treillis dans une direction de son plan provoque une déformation dans une autre direction contenue dans le plan. Dans ce cas, le treillis peut comporter des rangées de chevrons, deux rangées successives étant décalées d'un demi-pas, de sorte que les chevrons de deux rangées successives dessinent des losanges, des barreaux d'interconnexion reliant les pointes des chevrons de deux rangées successives, ces pointes étant les sommets de losanges.

Les barreaux peuvent également définir des lumières en forme de nid d'abeille. Cette forme est particulièrement adaptée à l'utilisation d'un électret rigide, déposé ponctuellement au centre des lumières.

De manière avantageuse, la première et la deuxième électrode sont telles que la capacité du condensateur formé par la première et la deuxième électrode séparées par la couche diélectrique est minimale. Pour cela, on peut prévoir que la deuxième électrode soit structurée de sorte que les surfaces en regard des première et deuxième électrodes soient réduites.

La présente invention a également pour objet un ensemble à capacité variable, comportant au moins deux systèmes selon la présente invention, lesdits systèmes étant superposés et une couche diélectrique étant interposée entre la deuxième électrode de l'une des systèmes et la première électrode de l'autre système.

La présente invention a également pour objet un système de conversion d'énergie mécanique en énergie électrique comportant au moins un système selon la présente invention, la conversion de l'énergie mécanique en énergie électrique ayant lieu lors d'une phase de déformation de la couche diélectrique à partir de sa forme initiale et lors de son retour d'une forme déformée à sa forme initiale.

Le système de conversion d'énergie mécanique en énergie électrique, peut être du type interrupteur, destiné à envoyer une commande à un appareil, et l'énergie électrique produite lors de la première phase de déformation est utilisée pour envoyer la commande à l'appareil, le système de conversion étant ainsi autoalimenté.

Le système à capacité variable peut avoir la forme d'un manchon cylindrique, le ou les fils étant enroulés le long de l'axe du manchon, ledit manchon étant fixé au niveau de ses extrémités axiales à deux éléments aptes à se rapprocher et à s'éloigner l'un de l'autre le long de l'axe du manchon, de sorte qu'un déplacement relatif des deux éléments déforme axialement le manchon. Dans une variante de réalisation, le système à capacité variable comporte entre ses couches au niveau des extrémités longitudinales du manchon fixées sur les éléments, un film rigide.

La présente invention a également pour objet un actionneur comportant au moins un système selon la présente invention, l'application d'une tension entre la première et la deuxième électrode provoquant une déformation dans un plan moyen du système et/ou dans une direction orthogonale au dit plan moyen, ou une déformation le long de l'axe longitudinal du manchon.

La présente invention a également pour objet un procédé de fabrication d'un système à capacité variable selon la présente invention, comportant les étapes de :

- dépôt de la première électrode sur une face de la couche diélectrique, par exemple par lithographie,
- dépôt d'un matériau destiné être polarisé pour former le premier électret dans la au moins une lumière de la première électrode, par exemple du téflon ou du parylène,
- polarisation dudit matériau,
- dépôt de la deuxième électrode sur l'autre face de la couche diélectrique, par exemple par lithographie.

Le procédé selon l'invention peut également comporter les étapes supplémentaires de :

- dépôt d'un matériau destiné être polarisé pour former le deuxième électret dans la au moins une lumière de la deuxième électrode, par exemple du téflon ou du parylène,
- polarisation dudit matériau.

Une étape d'application d'une précontrainte en étirement de la couche diélectrique peut également être prévue, préalablement au dépôt de la première électrode, ainsi qu'une étape de réajustement de la précontrainte après la polarisation du premier ou du deuxième électret.

Le procédé selon l'invention peut utiliser une couche diélectrique se trouvant sous la forme d'une bande dont des zones subissent simultanément les différentes étapes du procédé de fabrication.

A la fin du procédé de fabrication la bande ainsi obtenue peut par exemple être enroulée sur elle-même pour former un système à capacité variable multicouches.

BRÈVE DESCRIPTION DES DESSINS

La présente invention sera mieux comprise à l'aide de la description qui va suivre et des dessins en annexes sur lesquels :

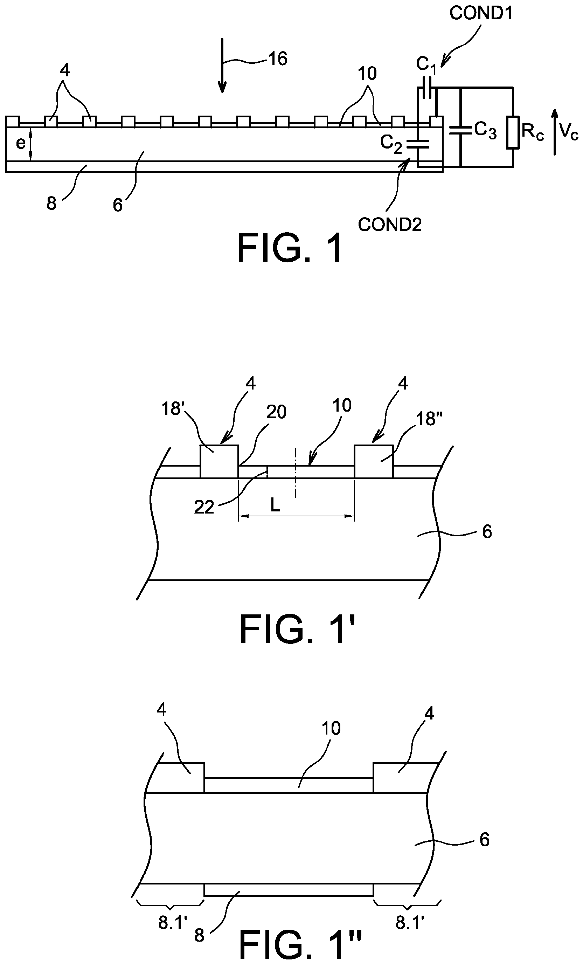

- la figure 1 est vue de côté d'un exemple de réalisation d'un système à capacité variable selon la présente invention dans un état non déformé,
- la figure 1' est une vue de détail du système de la figure 1,
- la figure 1" est une vue de détail d'une variante de réalisation du système de la figure 1,
- la figure 2 est une vue de côté du système de la figure 1 dans un état déformé,
- les figures 3A à 3E sont des exemples de réalisation, vue de dessus, de l'électrode ajourée pouvant être mise en oeuvre dans le système selon la présente invention,
- la figure 4 est une vue de côté d'un système selon l'invention mettant en oeuvre deux électrets de charges opposées, le système étant dans un état non déformé,
- la figure 5 est une vue de côté du système de la figure 4 dans un état déformé,
- la figure 6 est une vue de côté d'un système multicouches selon l'invention basé sur le système de la figure 1,

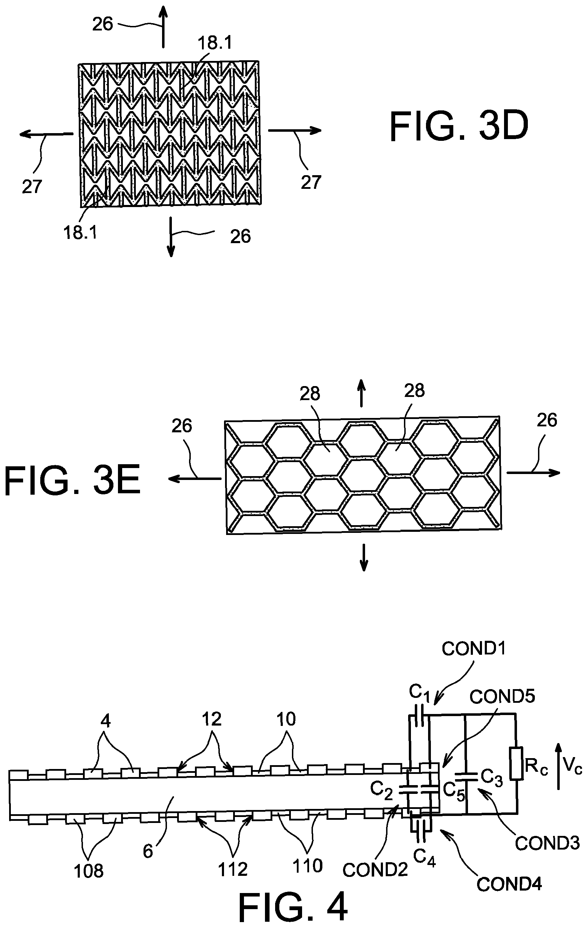

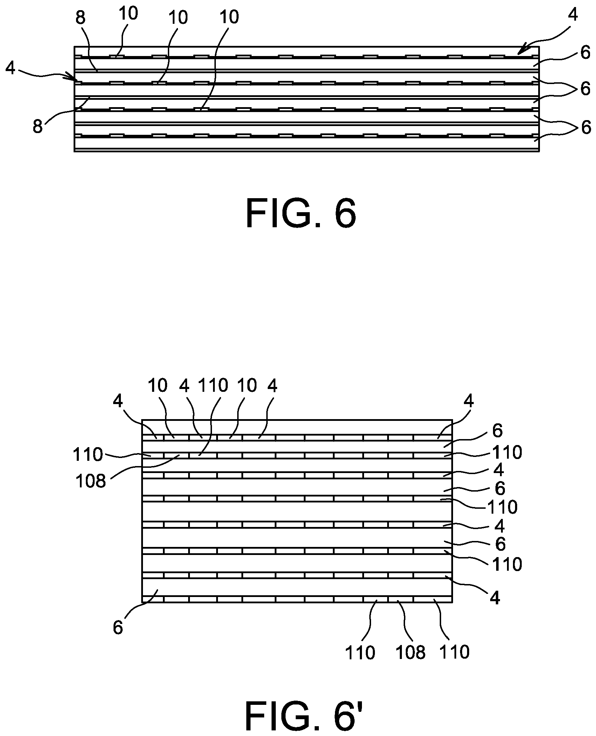

- la figure 6' est une vue de côté d'un système multicouches selon l'invention basé sur le système de la figure 4,

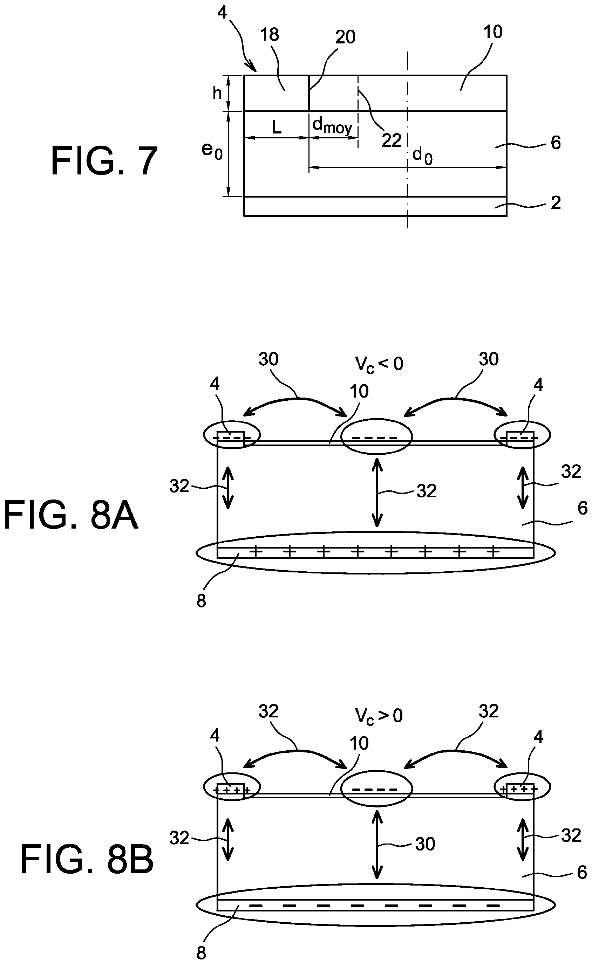

- la figure 7 est une représentation simplifiée d'un système selon l'invention,
- les figures 8A et 8B sont des représentations schématiques de côté d'un système selon l'invention fonctionnant comme actionneur,

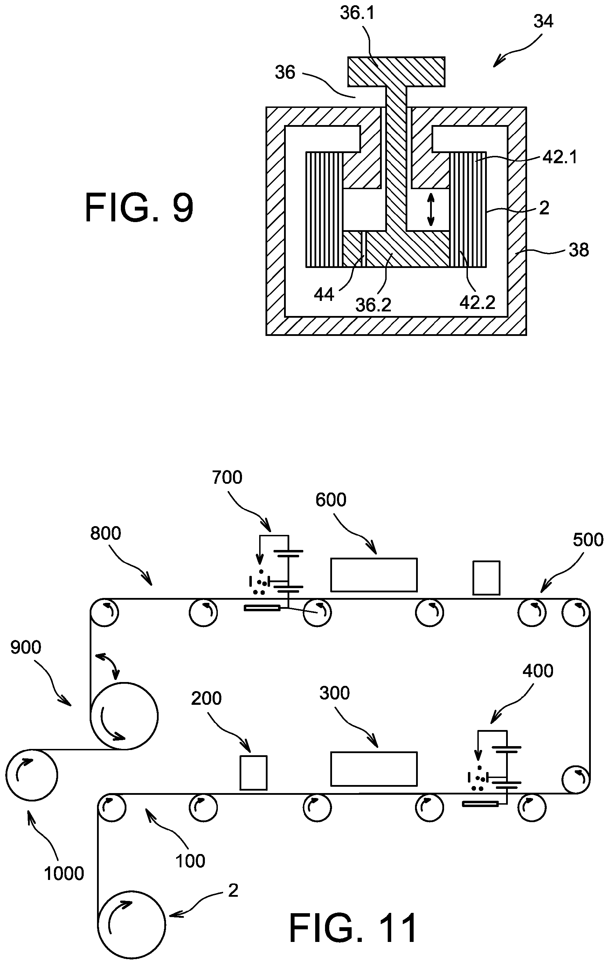

- la figure 9 est une représentation schématique d'un interrupteur mettant en oeuvre un système selon la présente invention,

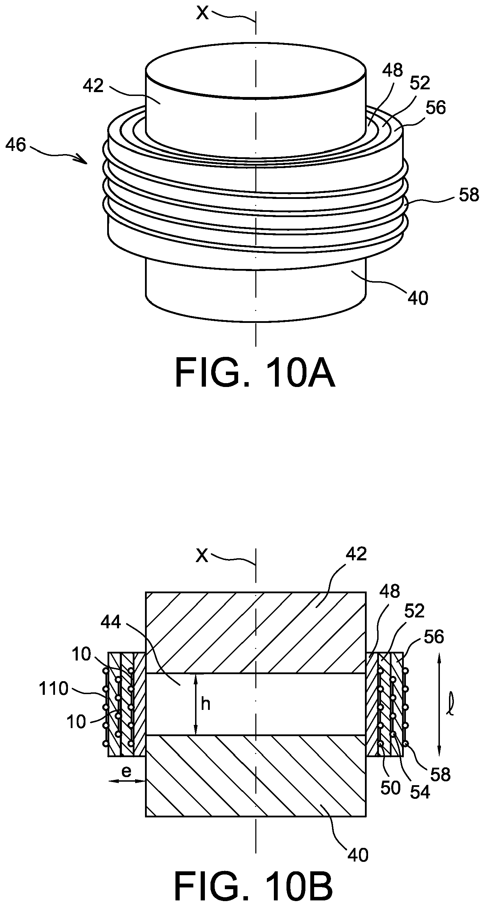

- la figure 10A est une vue en perspective d'un dispositif intégrant un système à capacité variable selon la présente invention selon un autre mode de réalisation ;
- la figure 10B est une vue en coupe longitudinale du dispositif de la figure 10A ;
- la figure 11 est une représentation schématique d'un exemple d'un procédé de réalisation d'un système selon la présente invention.

EXPOSÉ DÉTAILLÉ DE MODES DE RÉALISATION PARTICULIERS

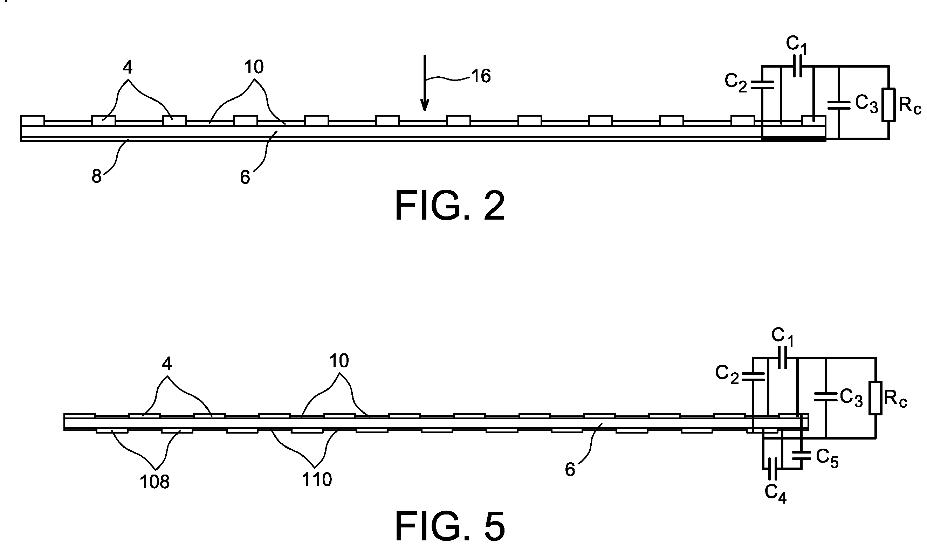

Sur les figures 1 et 2, on peut voir un exemple de réalisation d'un système à capacité variable 2 selon la présente invention dans un état non déformé et dans un état déformé respectivement.

Le système 2 selon la présente invention comporte une première électrode 4 formant une couche ajourée déposée sur une couche de matériau diélectrique 6, une deuxième électrode 8 formant une couche plane continue et un électret 10 disposé sur ou dans le matériau diélectrique dans les lumières 12 ménagées dans la première électrode 4.

La couche diélectrique 6 est déformable élastiquement. Par exemple, il peut s'agir de polymères diélectrique de type VHB®.

Le matériau formant la couche diélectrique est généralement peu ou pas compressible. Cette faible compressibilité ou absence de compressibilité permet avantageusement d'associer à une augmentation de surface une réduction d'épaisseur, et inversement à une réduction de surface une augmentation d'épaisseur, et donc d'obtenir un effet augmenté sur la valeur de la capacité électrique. En effet, la capacité est proportionnelle au rapport surface/épaisseur. Par conséquent, une augmentation de la surface et une diminution de l'épaisseur provoquent une forte augmentation de la capacité. De même une diminution de la surface implique une augmentation de l'épaisseur et, par conséquent une forte diminution de la capacité. Cependant un diélectrique ayant une compressibilité notable ne sort pas du cadre de la présente invention, par exemple dans le cas d'un diélectrique contenant des bulles de gaz.

La deuxième électrode 8 est apte à suivre les déformations de la couche diélectrique sans perdre ses propriétés de conductivité électrique, elle peut donc être réalisée en un matériau électriquement conducteur déformable élastiquement au moins dans son plan ou avoir une structure qui se déforme au moins dans son plan. La deuxième électrode peut être réalisée en cuivre, argent ou or en graisse d'argent, en poudre de carbone, en polymère conducteur ou par implantation d'ions sur la couche superficielle du polymère, comme cela est décrit dans le document « Electroactive Polymer Actuators and Devices » (EAPAD) 2008, edited by Yoseph Bar-Cohen, Proc. of SPIE Vol. 6927 69270W-1).

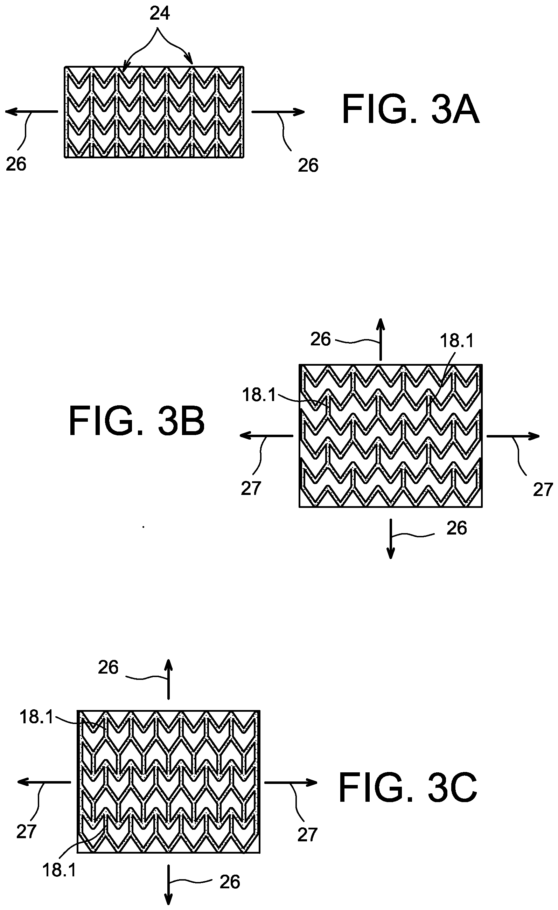

Lorsque la deuxième électrode est réalisée en cuivre, en or ou en argent, on peut prévoir une structuration de type ressort dont des exemples sont représentés sur les figures 3A à 3E, et seront décrits en détail dans la suite de la description.

La première électrode 4 ajourée a une structure telle qu'elle est apte à se déformer dans au moins une direction de l'espace de sorte à pouvoir suivre les déformations de la couche diélectrique 6, sans perdre ses propriétés de conductivité électrique.

L'électret 10 est disposé dans les lumières 12 pratiquées de la première électrode.

L'électret 10 peut soit :

- remplir les lumières 12 et venir en contact avec la première électrode 4. Dans ce cas, l'électret est apte à se déformer élastiquement pour suivre les déformations de la couche diélectrique,

- être déposé dans une zone centrale des lumières 12 pour être sensiblement à égale distance des bords de la lumière, dans ce cas l'électret peut être rigide puisqu'il n'a qu'une localisation ponctuelle, et ne subit pas ou peu de déformation.

La mise en place de l'électret peut être réalisée de différentes manières.

Dans le cas d'un électret solide, celui est placé au milieu des lumières 12 de manière relativement ponctuelle pour ne pas empêcher l'étirement/contraction de la couche diélectrique 6.

Dans le cas d'un électret déformable, celui-ci est par exemple collé sur la couche diélectrique. On peut également envisager un électret sous forme de poudre chargée déposée sur la couche diélectrique.

Il est également envisageable de polariser les zones de la surface libre de la couche diélectrique délimitées par les lumières 12 de la première électrode 4, par polarisation directe du diélectrique par ionisation, pour former l'électret directement dans la couche diélectrique. Cette méthode présente l'avantage de ne pas nécessiter la fixation préalable d'un matériau, la réalisation est donc simplifiée et plus rapide. Certains polymères, comme le Téflon, se prêtent à un tel procédé de réalisation de l'électret par polarisation.

Les méthodes de polarisation peuvent être de type corona. Pour cette méthode, on prévoit de créer un arc électrique sous faible courant entre une pointe et le diélectrique, ce qui a pour effet de ioniser des molécules de gaz séparant la pointe et le diélectrique et de les implanter dans la couche diélectrique. On peut également accélérer les électrons délivrés par un canon à électrons vers les zones de la couche diélectrique à ioniser. Ces méthodes de polarisation étant largement connues de l'homme du métier, elles ne seront pas décrites en détail.

A titre d'exemple avantageux, la couche diélectrique peut être réalisé en VHB4910®, qui est un polymère déformable ayant des propriétés adhésives, la fixation d'un électret solide ou sous forme de poudre sur la couche diélectrique est donc particulièrement simplifiée.

Dans le cas d'un électret sous forme de poudre, on peut prévoir :

- de déposer la poudre non polarisée sur la couche de polymère, par exemple de la poudre de parylène,
- de la polariser ensuite directement sur le polymère par une méthode classique, type décharge corona, accélération d'électrons ou accélération d'ions.

La première électrode 4 forme avec l'électret un premier condensateur COND1 à capacité variable. La deuxième électrode 8 forme ave l'électret 10 un deuxième condensateur à capacité variable COND2.

Sur la figure 1, sont schématisés les condensateurs COND1 et COND2, la capacité C1 représente la capacité électrique équivalente entre l'ensemble des barreaux conducteurs de la première électrode 4 et les charges électrique de l'électret, et C2 représente la capacité électrique équivalente totale entre la deuxième électrode 8 et les charges électriques stockées dans de la deuxième électrode 8.

A des fins de simplification pour l'explication, nous désignerons par C1 et C2 les capacités formées par une partie seulement des première et deuxième électrodes et de l'électret.

Comme on peut le voir sur la figure 1, la deuxième électrode 8 forme avec l'électret 10 et la couche diélectrique 6 un deuxième condensateur désigné COND2. La capacité C2 du deuxième condensateur COND2 est déterminée par la distance entre la deuxième électrode 8 et l'électret 10, qui est égale à l'épaisseur de la couche diélectrique 6, et par les surfaces en regard de la deuxième électrode 8 et de l'électret 10.

On rappelle que la capacité d'un condensateur est définie par :

$$C = \frac{\varepsilon_o \varepsilon_r S}{d} \qquad \text{(I)}$$

Avec $\varepsilon_0$ : permittivité électrique du vide,
$\varepsilon_r$: permittivité relative du diélectrique,
S : la surface en regard des deux plaques du condensateur,
d : la distance entre les deux plaques.

Dans la présente description, on entend par étirement de la couche diélectrique, une déformation de celle-ci telle qu'elle provoque une réduction de son épaisseur et une augmentation de sa surface dans son plan moyen. Cet étirement peut être obtenu, par exemple par l'application d'un effort orthogonal au plan moyen de la couche diélectrique en direction de la couche, ou par application d'efforts, vers l'extérieur, au niveau de sa périphérie extérieure dans le plan moyen de la couche diélectrique. L'étirement peut également être une phase de retour à une position repos, après une phase de compression latérale ou d'étirement selon l'épaisseur.

On entend par compression, une augmentation de l'épaisseur de la couche diélectrique et une diminution de sa surface dans son plan moyen. Cette compression peut faire suite à une phase de déformation par étirement, ou peut être obtenue par application d'un effort orthogonal au plan moyen de la couche en éloignement de la couche diélectrique, ou par une compression par une application d'un effort.

Lorsqu'un effort d'étirement est appliqué au système par application d'un effort schématisé par la flèche 16 sensiblement orthogonalement au plan moyen du système, la couche diélectrique 6 se déforme, voyant son épaisseur diminuer et sa surface augmenter, comme représenté sur la figure 2. La deuxième électrode 8 et l'électret suivent la déformation de la couche diélectrique 6. Par conséquent, les surfaces en regard augmentent, tandis que la distance les séparant diminue. En reprenant la relation I, un étirement de la couche diélectrique provoque l'augmentation de la capacité C2.

On rappelle que le matériau de la couche diélectrique 6 est peu ou pas compressible. Ainsi, il y a conservation du volume, i.e. une augmentation de surface par rapport à la diminution de l'épaisseur, et inversement lors de la déformation.

Lorsque le système subit une compression, par exemple lors d'un retour à un état non déformé après une phase d'étirement, il y a une diminution des surfaces en regard et un éloignement de la deuxième électrode 8 et de l'électret 10, la capacité C2 diminue.

La capacité du deuxième condensateur COND2 est donc variable.

Ainsi lors d'un cycle d'étirement-compression, apparaît un cycle d'augmentation et de diminution de la capacité C2 du deuxième condensateur COND2.

Sur les figures 3A à 3E, on peut voir différents exemples de réalisation de la première électrode 4 comportant des lumières. La première électrode 4 est formée par un réseau de barreaux 18 définissant des formes géométriques déformables. Les barreaux sont solidaires entre eux de sorte à former un treillis. Avantageusement, le treillis est fait d'une seule pièce par dépôt d'un conducteur, implantation d'ions sur la couche superficielle du diélectrique, gravure ou découpage d'une surface conductrice.

Cette réalisation en treillis est particulièrement avantageuse, puisqu'elle offre un grand nombre d'interconnexions. Grâce à cette structure, la rupture d'une des interconnexions ne provoque qu'une défaillance locale.

Cependant, une électrode formée par une pluralité de rangées en zigzag parallèles et non interconnectées ne sort pas du cadre de la présente invention.

Sur la figure 1', on peut voir une vue agrandie de la première électrode 4 et de l'électret 10, plus particulièrement on peut voir deux barreaux 18', 18" séparés par l'électret 10.

La première électrode 4 et l'électret 10 forment également un premier condensateur COND1. Mais contrairement, au deuxième condensateur COND2, les surfaces en regard du condensateur ne sont pas horizontales comme dans la représentation de la figure 1, mais sont verticales. Comme on peut le voir sur la figure 1', la face en regard 20 de la première électrode 4 est portée par une face latérale du barreau 18', la face 22 de l'électret en regard de la face 20 est formée par une section verticale de l'électret. On considère que la face 22 de l'électret se situe au milieu de la moitié de la surface d'électret du côté du barreau 18'. Cette hypothèse s'applique dans le cas d'un électret remplissant la lumière 12. Le milieu de la moitié correspond à la distance moyenne des charges d'une des deux électrodes 18' ou 18" si l'électret s'étale sur tout l'espace inter-électrode et qu'il possède une densité de charge homogène sur toute cette largeur.

Dans le cas d'un électret ponctuel, celui-ci est placé de préférence au milieu des deux électrodes.

Ainsi pour une distance L entre les barreaux 18', 18", la distance entre les plaques du premier condensateur COND1 est L/4.

Chaque barreau 18 porte deux faces, formant chacune une plaque d'un condensateur.

Lorsque la couche diélectrique 6 est étirée, la distance entre deux barreaux 18', 18" augmente, comme on peut le voir sur la figure 2. Par conséquent la distance entre les deux faces en regard augmente. Par contre, les surfaces en regard ne sont pas modifiées, puisque, lorsque les épaisseurs de l'électret et de la première électrode diminuent, leurs profondeurs (non visibles) augmentent. En reprenant la relation (I), lors d'un étirement, la capacité C1 du premier condensateur COND1 diminue, tandis que lors d'une compression, celle-ci augmente.

On peut donc résumer l'évolution des capacités C1, C2 des condensateurs COND1, COND2 respectivement comme suit :

|  | C1 | C2 |
|---|---|---|
| Etirement | ↓ | ↑ |
| Compression | ↑ | ↓ |

Par conséquent, lors de la déformation du système les capacités des condensateurs COND1 et COND2 varient en sens inverse.

La relation reliant la charge à la capacité est la suivante :

$$Q = C \times V \qquad (II)$$

Q: charge du condensateur,
C : capacité du condensateur,
V : tension aux bornes du condensateur.

Lorsque le système est étiré, il y a augmentation de la capacité C2 et diminution de la capacité C1.

Si la tension $V_C$, aux bornes de la première et de la deuxième électrode, est constante, alors la charge $Q_2$ augmente lorsque $C_2$ augmente et la charge $Q_1$ diminue lorsque $C_1$ diminue, et inversement.

Cette variation en opposition des capacités C1 et C2, provoque donc une variation de la charge entre la première et la deuxième électrode, ce qui conduit à une redistribution des charges électriques entre les électrodes supérieure et inférieure via une résistance de charge Rc reliant la première électrode 4 et la deuxième électrode 8. Il y a donc production d'énergie électrique. La résistance de charge $R_C$ peut être une batterie ou un dispositif utilisateur directement.

Sur la figure 1, est également représenté un troisième condensateur COND3 de capacité C3 formé entre la première électrode 4 et la deuxième électrode 8, qui se trouve connecté électriquement en parallèle avec les condensateurs COND1 et COND2.

Il est préférable que cette capacité C3 ait une valeur négligeable devant C1 et C2 pour éviter de limiter le niveau de tension et la puissance de sortie. Pour cela, on prévoit par exemple de réduire les surfaces en regard des électrodes 4, 8. Cela est obtenu, par exemple en minimisant la largeur des barreaux de la première électrode et/ou en réalisant la deuxième électrode de sorte qu'elle ne se trouve pas que partiellement en face des barreaux de la première électrode. Cette structure est cependant telle qu'elle assure une continuité électrique dans toute la deuxième électrode. Par exemple, sur la figure 1", on a représenté un détail d'un système selon l'invention dans lequel la deuxième électrode 8' est structurée de sorte à réduire sa surface faisant face à la première électrode. Les zones 8.1' de la deuxième électrode 8' situées en face de la première électrode sont omises. On peut donc envisager de réaliser une deuxième électrode dont la structure soit sensiblement « un négatif » de la structure de la première électrode tout en réalisant la continuité électrique.

Dans l'exemple représenté, la première électrode comporte une pluralité de lumières, mais une électrode ne comportant qu'une lumière ne sort pas du cadre de la présente invention. Cependant un grand nombre de lumières permet de former un grand nombre de premiers condensateurs, et donc d'augmenter la quantité d'énergie convertie. Il est avantageux que la largeur des lumière soit de l'ordre de l'épaisseur du diélectrique, avec une largeur des lumières inférieure à l'épaisseur en situation compressée et à une largeur des lumières supérieure à l'épaisseur en situation étirée, de façon à ce que l'électret influence préférentiellement l'électrode 4 en position compressée, puis l'électrode 8 en position étirée.

En outre, l'exemple représenté comporte des lumières dont les bords sont sensiblement orthogonaux à la couche diélectrique, mais il est bien entendu que des lumières ayant des bords inclinés ne sortent pas du cadre de la présente invention.

La couche diélectrique est par exemple un polymère de type VHB4910®. Les électrodes peuvent être réalisées en cuivre, en argent, en graisse d'argent, en poudre de carbone, en or.... L'électret peut être basé sur du parylène, du Téflon ou du Kapton® dans lesquels des charges électriques ont été injectées, par des techniques connues comme décrites précédemment.

Nous allons maintenant décrire plus particulièrement les exemples de réalisation de la première électrode ajourée représentés sur les figures 3A à 3E.

De manière générale, on cherche à réaliser une première électrode présentant des lumières de tailles et de formes sensiblement constantes afin que les efforts électrostatiques soient sensiblement homogènes sur toute la surface de l'électrode. En outre, on recherche des formes qui ne s'opposent pas à la déformation de la couche diélectrique. Par conséquent, on cherche une structure d'électrode qui se déforme de manière importante (>1%) sans engendrer de déformation significative du matériau en lui-même, i.e. dont la modification de forme est obtenue préférentiellement par flexion des différentes parties de la structure et non par compression/étirement du matériau lui-même. Ceci est particulièrement le cas lorsque le matériau d'électrodes offre une faible aptitude à la déformation, par exemple lorsque les barreaux de la première électrode sont réalisés en matériau conducteurs métalliques. Enfin, il est souhaitable que les connexions entre barreaux soient relativement nombreuses pour assurer une continuité électrique élevée.

Sur la figure 3A, les barreaux dessinent des sapins 24 disposés les uns à côté des autres et reliés les uns aux autres par au niveau des extrémités des branches des sapins. Les barreaux sont connectés de sorte à assurer une continuité électrique dans toute la surface de l'électrode.

Cette électrode est déformable dans la direction des flèches 26. Elle s'allonge dans la direction des flèches 26, par contre elle ne se déforme que très peu dans la direction orthogonale des flèches 26.

Cette structure d'électrode présente un grand nombre d'interconnexions entre barreaux, et une homogénéité dans la forme des lumières, celles-ci étant toutes identiques.

Sur la figure 3B, les barreaux dessinent des lignes chevrons disposées parallèlement les unes aux autres et connectées les unes aux autres par des barreaux de connexion transverses 18.1. A l'inverse de la structure de la figure 3A, les barreaux de connexion transverses 18.1 entre trois lignes de chevrons successifs ne sont pas alignés.

Cette électrode est déformable dans la direction des flèches 26. Elle s'allonge dans la direction des flèches 26, par contre elle ne se déforme que très peu dans la direction 27 orthogonale aux flèches 26. Elle présente également des lumières de même forme, les efforts électrostatiques sont donc sensiblement homogènes.

La structure de la figure 3C est proche de celle de la figure 3B. Elle diffère de celle-ci en ce que des barreaux de connexion transverses 18.1 sont prévus à tous les chevrons et décalés d'un pas entre deux lignes de chevrons successives.

Cette électrode présente différentes formes de lumières. Cependant, elle comporte une grande densité de connexions entre barreaux, ce qui permet d'avoir une bonne continuité électrique.

Cette structure se déforme essentiellement dans la direction des flèches 26.

La structure de la figure 3D présente l'avantage de se déformer dans la direction des flèches 26 et simultanément dans celle des flèches 27. En effet, un étirement de la couche diélectrique dans une première direction tend à provoquer aussi une dilatation dans une direction orthogonale à la première direction contenue dans le plan de la couche diélectrique souple. Cette configuration permet de maximiser les variations de capacité et donc la quantité d'énergie récupérable pour une amplitude d'étirement donnée.

La structure de la figure 3D comporte des lignes de chevrons, les chevrons de deux lignes successives étant opposés deux à deux. Des barreaux de connexion transverses 18.1 sont prévus entres les pointes de deux chevrons de deux lignes successives, les chevrons connectés étant ceux dont les pointes sont les plus éloignées.

La structure de la figure 3E présente une disposition des barreaux telle qu'ils définissent des nids d'abeille 28. Cette structure présente l'avantage de permettre l'utilisation d'électrets plus rigides disposés de manière ponctuelle au centre des lumières, puisque les lumières présentent une forme offrant une distance entre les barreaux d'une lumière et une zone centrale de la lumière plus homogène que les autres structures.

Il est bien entendu que d'autres structures d'électrodes peuvent convenir.

Sur les figures 4 et 5, on peut voir une variante de réalisation d'un système à capacité variable selon la présente invention comportant à la fois un premier électret 10 du côté de la première électrode 4 et un deuxième électret 110 du côté de la deuxième électrode 108.

Nous allons décrire en détail cette variante de réalisation.

La première électrode est similaire à celle du système de la figure 1. Par contre la deuxième électrode 108 présente une structure ajourée déformable au moins dans son plan, similaire à celle de la figure 1, un deuxième électret 110 étant disposé dans chaque lumière 112 de la deuxième électrode 108.

Le premier électret 10 et le deuxième électret 110 sont de charges opposées. Par exemple, si le premier électret 10 est chargé négativement, le deuxième électret 110 est chargé positivement. Le premier électret 10 et le deuxième électret 110 peuvent être réalisés dans le même matériau.

Le système de la figure 4 ou 5 comporte un premier condensateur COND1 de capacité C1 entre le premier électret 10 et la première électrode 4, un deuxième condensateur COND2 de capacité C2 entre le premier électret 10 et la deuxième électrode 108, un troisième condensateur COND3 de capacité C3 entre la première 4 et la deuxième électrode 108, un quatrième condensateur COND4 de capacité C4 entre la deuxième électrode 108 et le deuxième électret 110 et un cinquième condensateur COND5 de capacité C5 entre la première électrode 4 et le deuxième électret 110.

Le deuxième électret 110 est déposé sur la couché diélectrique 6 ou dans la couche diélectrique 6, dans les lumières 112 de la deuxième électrode 108 de manière similaire au premier électret 10.

Nous allons maintenant expliquer le comportement des différentes capacités en fonction du type de déformation subi par la couche diélectrique 6.

Lors d'un étirement de la couche diélectrique 6, de manière similaire au système de la figure 1, C1 diminue puisque la distance entre le premier électret 10 et la première électrode 4 augmente. Le comportement du quatrième condensateur COND4 est identique à celui du premier condensateur COND1, la capacité C4 diminue également. Quant à la capacité C2 du deuxième condensateur, elle augmente, ainsi que celle C5 du cinquième condensateur C5, celles-ci étant directement proportionnelles à l'épaisseur et à la surface de la couche diélectrique 6.

A l'état initial, la première électrode 4 est initialement soumise à l'influence du premier électret 10 qui se trouve dans les lumières 12. Lors de l'étirement, la première électrode 4 est de moins en moins soumise à l'influence du premier électret 10, et de plus en plus soumise à l'influence du deuxième électret 110. Ce changement d'influence s'opère également pour la deuxième électrode 108, qui est initialement sous l'influence du deuxième électret 110, puis progressivement soumise à l'influence du premier électret 10.

Ce changement d'influence engendre alors une redistribution des charges électriques sur les première 4 et deuxième 108 électrodes, via une résistance de charge $R_C$ entre les deux électrodes 4, 108 et le troisième condensateur COND3.

Comme dans le système de la figure 1, il est avantageux de réduire la capacité C3 du troisième condensateur COND3. Ceci peut être particulièrement aisé dans ce cas, puisque la deuxième électrode est ajourée et permet de décaler les surfaces des première 4 et deuxième 108 électrode pour réduire les surfaces en regard.

Dans le cas d'une compression, l'évolution des capacités est inversée.

Dans le tableau suivant, sont rassemblées les évolutions des capacités C1, C2, C3, C4, C5 des condensateurs COND1, COND2, COND3, COND4, COND5 respectivement :

|  | C1 | C2 | C3 | C4 | C5 |
|---|---|---|---|---|---|
| Etirement | ↓ | ↑ | ↑ | ↓ | ↑ |
| Compression | ↑ | ↓ | ↓ | ↑ | ↓ |

Cette variante de réalisation permet de récupérer une quantité d'énergie supérieure à celle récupérée dans le système de la figure 1, puisque l'énergie de déplacement des charges des deux électrets est convertie.

Sur la figure 6, on peut voir un exemple de réalisation d'un système multicouches obtenu par la superposition de systèmes selon la figure 1. Dans cet empilement, les première 4 et deuxième 8 électrode face à face sont séparées par une couche diélectrique 6.

Cette structure superposée permet d'augmenter l'énergie récupérée.

Dans l'exemple représenté les zones d'électret sont alignées, mais cette disposition n'est en aucun cas limitative. Dans le cas du système de la figure 4 et 5 dans lequel des électrets sont disposés sur les deux faces du diélectrique, il est par contre souhaitable, dans le cas d'un système multicouches, de superposer les zones d'électrets d'une couche avec les électrodes d'une autre couche, comme cela est représenté sur la figure 6'.

Nous allons maintenant donner, à titre d'exemple le calcul d'une puissance récupérable par un système similaire à celui de la figure 1.

Nous considérons un système dans lequel la couche diélectrique 6 est en VHB4910®, dont la permittivité relative $\varepsilon_r$ est égale à 4,8. A l'état de repos, la couche diélectrique 6 a une épaisseur $e_0 = 50~\mu m$ et une surface $S_0 = 1~cm^2$.

Pour le calcul, nous considérons que la première électrode 4 comporte un barreau 18 et un électret 10 comme sur la figure 7, ce qui correspond à un motif élémentaire. La longueur de l'électret est $d_0 = 20~\mu m$, la largeur du barreau 18 est égale à $L = 5~\mu m$ et la hauteur du barreau 18 est égale à $h = 5~\mu m$.

On considère que le barreau 18 et l'électret 10 ont la même épaisseur. En outre, on considère que la face 22 de l'électret formant la plaque du deuxième condensateur se situe au milieu de la moitié de la surface d'électret, i.e. la distance moyenne des charges d'un des barreaux de l'électrode 18, donc à une distance de 5 $\mu$m de la face 22.

Par ailleurs, la surface de la première électrode 4 représente $1/5^{ème}$ de la surface SO et la surface de l'électret 10 représente $4/5~^{ème}$ de la surface S0.

Nous allons calculer les valeurs des capacités électriques C1, C2 et C3 avant étirement, notées $C_{10}$, $C_{20}$, $C_{30}$ respectivement :

$$C_{10} = \frac{\varepsilon_0 \varepsilon_r S_{lattéraleElectrodeSup}}{d_{moy0}} = \frac{\varepsilon_0 \varepsilon_r \frac{2}{5}~cm^2}{d_{moy}} = \frac{8.84 \cdot 10^{-12} \cdot 4.8 \cdot \frac{2}{5} \cdot 10^{-4}}{5 \cdot 10^{-6}} = 339\,pF$$

$$\left( \begin{array}{l} d_{moy} \text{ représente la distance moyenne des charges de l'électret par rapport} \\ \text{à l'électrode supérieure.} \end{array} \right)$$

$$C_{20} = \frac{\varepsilon_0 \varepsilon_r S_{électret0}}{e_0} = \frac{\varepsilon_0 \varepsilon_r \frac{4}{5} \cdot 10^{-4}}{50 \cdot 10^{-6}} = 68\,pF$$

$$C_{30} = \frac{\varepsilon_0\varepsilon_r S_{ElectrodeSup}}{e_0} = \frac{\varepsilon_0\varepsilon_r \frac{1}{5}\cdot 10^{-4}}{50\cdot 10^{-6}} = 17\,pF$$

Nous calculons maintenant les valeurs des capacités électriques après étirement, notées $C_{11}$, $C_{21}$, $C_{31}$ respectivement. Nous considérons un étirement d'un facteur 2 et un volume constant, i.e. l'épaisseur de la couche diélectrique est divisée par deux tandis que la surface de la couche diélectrique est multipliée par 2:

$$C_{11} = \frac{\varepsilon_0\varepsilon_r S_{lattéraleElectrodeSup}}{d_{moy1}} = \frac{\varepsilon_0\varepsilon_r \frac{2}{5}\cdot 10^{-4}}{10\cdot 10^{-6}} = 170\,pF$$

$$C_{21} = \frac{\varepsilon_0\varepsilon_r S_{électret1}}{e_1} = \frac{\varepsilon_0\varepsilon_r 2\cdot\frac{4}{5}\cdot 10^{-4}}{25\cdot 10^{-6}} = 272\,pF$$

$$C_{31} = \frac{e_0}{e_1}C_{30} = 34\,pF$$ (on considère que la surface de l'électrode supérieure ne change pas).

Soit une charge négative $Q_0$ stockée dans l'électret 10 tel que le champ électrique ne dépasse pas $E_0 = 100$ V/$\mu$m dans la couche diélectrique 6 pour éviter tout claquage diélectrique. En position initiale, le potentiel de l'électret 10 à la distance $d_{moy0}$ de la première électrode 4 est alors égal à $V_0 = V_{20} = -V_{10} = -d_{moy0}E_0 = -500$ V (on considère que $V_{30}=0$V, sortie déchargée), donc $E_0 = 100$ V/$\mu$m.

Il a été montré qu'il était possible de créer un champ électrique de 204 V/$\mu$m avec un électret, par exemple dans le document « Parylene HT based electret rotor generator », MEMS 2008, Tucson, AZ, USA, January 13-17, 2008, p984-987. Le choix d'un champ électrique de 100 V/$\mu$m est donc complètement fondé.

La distribution des charges électrique en position initiale est la suivante :

$$Q_0 = (C_{10} + C_{20})V_0 = -203\,nC$$

$$Q_{10} = C_{10}V_{10} = -C_{10}V_0 = 169\,nC$$

$$Q_{20} = C_{20}V_0 = -34\,nC$$

$$Q_{30} = 0\,nC$$

Nous allons maintenant calculer le gain en énergie électrique potentielle suite à la déformation de la couche diélectrique avec, pendant la déformation une consommation nulle ; i.e. $R_C$ = infinie. Le circuit électrique est alors formé de trois condensateurs en série, la circulation d'un courant électrique dans le circuit engendre alors la même variation de charge électrique dans chacun des condensateurs. Le système peut alors être décrit par le système d'équation suivant :

$$\begin{cases} -\Delta Q_1 = -\Delta Q_2 = \Delta Q_3 \quad avec \quad \begin{vmatrix} \Delta Q_1 = C_{11}V_{11} - Q_{10} \\ \Delta Q_2 = C_{21}V_{21} - Q_{20} \\ \Delta Q_3 = C_{31}V_{31} - Q_{30} \end{vmatrix} \\ V_{31} = V_{21} + V_{11} \end{cases}$$

$$\begin{cases} V_{21} = \dfrac{C_{11}Q_{20} + C_{11}Q_{30} + C_{31}Q_{20} - C_{31}Q_{10}}{C_{11}C_{21} + C_{11}C_{31} - C_{21}C_{31}} = -207\,V \\[3mm] V_{31} = \dfrac{C_{11}Q_{20} + C_{11}Q_{30} + C_{21}Q_{10} - C_{21}Q_{30}}{C_{11}C_{21} + C_{11}C_{31} + C_{21}C_{31}} = 658\,V \end{cases}$$

La capacité équivalente $C_{eq}$ vue par la charge $R_c$ correspond aux capacités C1 et C2 en série, toutes deux en parallèle avec C3, celle-ci est donc égale à :

$$C_{eq} = \frac{C_{11}C_{21}}{C_{11} + C_{21}} + C_{31} = 138.6\,pF$$

L'énergie électrique potentielle $E_p$ disponible à la sortie du système, suite à la déformation vaut alors :

$$E_p = \frac{1}{2}C_{eq}V_{31}^2 = 30\,\mu J \ .$$

Si on considère un système multicouches de 200 couches similaire à celui de la figure 6, en rapportant cette énergie au volume de la couche diélectrique utilisée, on obtient une densité d'énergie de $30\mu J*200$couches = 6 mJ/cm$^3$,

Il est à noter qu'une énergie équivalente est récupérable suite au retour en situation initiale du système. Un cycle complet permet donc de récupérer 12 mJ/cm$^3$, soit par exemple, pour une fréquence de fonctionnement de 1 Hz (correspondant par exemple environ à la fréquence d'application d'un effort sur une chaussure pour un marcheur), une puissance récupérable de 12 mW/cm$^3$.

Le système à capacité variable selon la présente invention a été appliqué à la récupération d'énergie, mais il peut également être utilisé en tant qu'actionneur. Grâce au système selon la présente invention, il est possible de réaliser un actionneur permettant à la fois d'étirer et de contracter la couche diélectrique, ce qui n'est pas le cas des actionneurs connus dans lesquels seul l'étirement peut être favorisé, la contraction se faisant uniquement par les contraintes interne de la couche diélectrique.

Sur la figure 8A est schématisé un fonctionnement en mode étirement, et sur la figure 8B est schématisé un fonctionnement en mode compression. Le mode de déformation dépend du signe de la tension de commande $V_C$ entre la première 4 et la deuxième 8 électrode. Les flèches symbolisent des interactions et non un type d'interaction particulier.

On considère un électret 10 polarisé négativement.

Lorsque la tension de commande $V_C$ est négative, la deuxième électrode 8 est polarisée positivement et la première électrode 4 est polarisée négativement. Par conséquent, comme cela est schématisé sur la figure 8A, il y a répulsion entre l'électret et la première électrode 4 symbolisée par les flèches 30, et attraction, symbolisée par les flèches 32, entre l'électret 10 et la deuxième électrode 8. L'épaisseur de la couche diélectrique 6 diminue et sa surface augmente.

Lorsque la tension de commande $V_C$ est positive, la deuxième électrode 8 est polarisée négativement et la première électrode 4 est polarisée positivement. Par conséquent, comme cela est schématisé sur la figure 8B, il y a répulsion, symbolisée par les flèches 30, entre l'électret 10 et la deuxième électrode 8, provoquant une augmentation de l'épaisseur de la couche diélectrique 6. Il y a attraction, symbolisée par les flèches 32, entre l'électret 10 et la première électrode 4, provoquant une réduction de surface de couche diélectrique 6.

Il est à noter qu'il y a également apparition d'efforts d'attraction entre les première 4 et deuxième 8 électrodes, ces efforts s'opposent avec l'effet de compression recherché. Cependant, en minimisant la capacité C3 entre la première électrode 4 et la deuxième électrode 8, par exemple en minimisant la largeur des barreaux, alors cet effet d'attraction peut être considéré comme négligeable par rapport aux autres efforts électrostatiques.

Il est à noter que l'épaisseur d'un système selon l'invention est suffisamment faible pour que les déformations provoquées par les efforts d'attraction et de répulsion entre l'électret et la première électrode soient répartis de manière homogène dans toute l'épaisseur du système. Par ailleurs, concernant les déformations provoquées par les efforts d'attraction et de répulsion entre l'électret et la deuxième électrode, celles-ci apparaissent dans tout le système. Il y a donc bien une augmentation ou une réduction de l'épaisseur uniformément répartie.

Le système de conversion d'énergie réalisable grâce à l'invention présente l'avantage de ne plus nécessiter de moyens spécifiques pour polariser la structure à chaque cycle pour réaliser des cycles de récupération d'énergie, et ceci grâce à la mise en oeuvre d'électret. Ceci permet de simplifier le système puisque l'électronique de transfert de charge électrique vers la structure électrostatique peut être supprimée. Par ailleurs, il n'est plus nécessaire de disposer d'une énergie minimale et de faire une détection de la capacité maximale. Les pertes électriques engendrées par cette électronique sont donc supprimées.

En outre, le système selon la présente invention présente l'avantage de permettre une récupération de l'énergie à la fois durant la période d'étirement et durant la période de relâchement. Les systèmes de l'art antérieur, ne permettant une récupération que durant la période de relâchement.

Cette récupération durant ces deux phases présente l'avantage de disposer d'une énergie électrique dés l'étirement de la couche diélectrique. Cette génération d'énergie rapide est particulièrement intéressante, dans le cas d'un interrupteur ou d'une télécommande sans-fil, puisque l'interrupteur ou la télécommande utilise l'énergie produite par l'étirement de la couche diélectrique pour envoyer la commande avant que l'utilisateur ne relâche sa pression sur l'interrupteur ou le bouton de la télécommande. Ainsi, il n'est pas nécessaire de prévoir un moyen pour stocker l'énergie pour l'envoi de la commande, celle-ci est disponible immédiatement, contrairement aux dispositifs de l'état de la technique pour lesquels l'énergie n'est récupérée que lorsque la couche diélectrique est relâchée.

Ceci est également particulièrement avantageux pour tout capteur utilisant la déformation pour détecter et mesurer une grandeur physique, par exemple un capteur de pression ou de déformation. Un capteur de pression, comportant un système de génération d'énergie électrique selon la présente invention, est d'une part auto-alimenté puisque c'est la déformation de la couche diélectrique qui génère l'énergie électrique, et permet d'autre part de connaître la valeur de la pression détecté par le capteur avant que celle-ci soit retirée, i.e. avant la fin de l'étirement de la couche diélectrique.

Par ailleurs, dans le cas d'un interrupteur ou d'une télécommande, l'étirement de la couche diélectrique est imposée par l'utilisateur, par conséquent la récupération d'énergie n'est pas commandée par le comportement de la couche diélectrique lors de son retour dans une position contractée, elle est donc potentiellement plus efficace et plus rapide.

Sur la figure 9, on peut voir un exemple de réalisation d'un interrupteur 34 selon la présente invention comportant un système 2 à capacité variable selon l'invention.

Le système 2 selon l'invention est réalisé à partir d'une bande similaire à celle de la figure 1 ou de la figure 4, enroulée sur elle-même de sorte à former un système multicouche en forme de bobine.

L'interrupteur comporte un bouton poussoir 36 monté mobile axialement dans un support 38. Le bouton poussoir comporte une extrémité 36.1 destiné à servir d'interface pour l'utilisateur et une deuxième extrémité 36.2 solidaire en déplacement du système 2 et destiné à provoquer la déformation du système 2. Le système 2 est fixé par une première extrémité longitudinale 42.1 au support 38 et par une deuxième extrémité longitudinale 42.2 au piston 36.

Un passage d'air 44 est prévu dans le piston 36.2 pour éviter l'apparition d'une suppression dans le système 2.

Lorsque l'opérateur enfonce le bouton poussoir, la deuxième extrémité 36.2 du bouton poussoir 36 coulisse vers le bas, dans la représentation de la figure 9, provoquant un étirement du système et une diminution des capacités C1 et une augmentation des capacités C2, il y a conversion de l'énergie mécanique servant au déplacement du bouton poussoir en énergie électrique, cette énergie étant directement disponible pour la commande associée à l'interrupteur. Lorsque l'effort sur le bouton poussoir 36 est relâché, les capacités C1 diminuent et les capacités C2 augmentent, provoquant également une conversion d'énergie mécanique en énergie électrique.

Sur les figures 10A et 10B, on peut voir un autre mode de réalisation d'un système à capacité variable selon la présente invention intégré à un dispositif de récupération d'énergie.

Ce dispositif comporte un premier support 40 de forme cylindrique d'axe X et un deuxième support 42 maintenu suspendu au dessus du support 40 le long de l'axe X. Le premier support 40 et le deuxième support 42 sont de préférence rigides, pour que l'énergie serve principalement à la déformation des couches formant les condensateurs.

Le deuxième support 42 est de forme cylindrique et d'axe X, dont la section présente des dimensions similaires à celle du support 40.

Un espace vide 44 de hauteur h est ménagé entre la face supérieure du support 40 et la face inférieure du deuxième support 42. Il est bien entendu, que les adjectifs « supérieure » et « inférieure » ne sont pas limitatifs et l'on pourrait prévoir que l'axe X soit à l'horizontal les deux faces étant alors au même niveau.

Le dispositif comporte un manchon 46 reliant le premier 40 et le deuxième 42 support maintenu celui-ci à distance du support 40. Le manchon 46 forme une paroi latérale pour l'espace vide 44. Le manchon présente une hauteur l et une épaisseur radiale e.

Dans l'exemple représenté, le manchon 46 comporte un première couche 48 radialement intérieure en matériau élastiquement déformable, plus particulièrement étirable dans la direction de l'axe X, un fil conducteur électrique 50 enroulé autour de la première couche 48 et formant une hélice sensiblement sur la hauteur de l'espace vide 44, une deuxième couche 52 autour du fil 50 en matériau diélectrique élastiquement déformable, plus particulièrement étirable dans la direction de l'axe X, un deuxième fil électriquement conducteur 54 enroulé en hélice autour de la deuxième couche 52 sensiblement sur la hauteur de l'espace vide 44, une troisième couche 56 en matériau diélectrique élastiquement déformable, plus particulièrement étirable dans la direction de l'axe X, et un troisième fil électriquement conducteur 58 enroulé en hélice autour de la troisième couche 56 sensiblement sur la hauteur de l'espace vide 44.

En outre, les fils 50, 54, 58 sont disposés de manière décalée le long de l'axe X de sorte que les spires formées par deux films directement adjacents ne se superposent pas en considérant une quelconque direction radiale.

Les fils 50, 54, 58 sont connectés électriquement pour permettre la récupération des charges générées.

De plus, le dispositif comporte un matériau d'électret 10, entre les spires des fils 50 et 58, et un matériau d'électret 110 de polarité opposée à celle de l'électret 10 entre les spires du fil 54. Les matériaux 10, 110 sont par exemple déposés sur les couches diélectriques. Plus généralement, le manchon comporte des couches alternées d'électrets de polarités opposées.

Les ensembles formés par les spires, les couches électriquement isolantes et les électrets constituent des condensateurs à capacité variable, les spires forment les électrodes.

La polarisation est appliquée par les électrets 10, 110. Le système à capacité variable est très proche de celui de la figure 4, les électrodes ajourées étant remplacées par les spires.

Les capacités des condensateurs varient lorsqu'un effort est appliqué le long de l'axe X dans le sens de la flèche F, par exemple un effort de traction.

La première couche 48 sert à la fixation du premier fil 50 sur le support et l'élément suspendu, il ne sert donc pas de diélectrique dans un condensateur.

La couche 48 et les couches 52 et 56 peuvent être en polymère.

Le fonctionnement est identique à celui décrit précédemment pour les figures 4 et 5, et ne sera pas décrit en détail.

On peut envisager de remplacer l'une des électrodes sous forme de fil enroulé par une couche continue de matériau électriquement conducteur, cette structure est alors proche de celle de la figure 1. On peut également envisager d'alterner les électrodes sous forme de fil et sous forme de couche.

Il est bien entendu que le nombre d'électrodes n'est pas limitatif.

De manière avantageuse, les couches et les fils sont collés.

Dans le cas où l'on souhaite réaliser un dispositif avec un grand nombre de couches, on prévoit avantageusement d'insérer entre des paires de couches un film rigide. Ce film est disposé au niveau des zones d'encastrement du manchon sur le premier et le deuxième support, i.e. les zones des couches situées de part et d'autre de l'espace vide 44. La présence de ce film ne gêne pas la déformation des couches et des spires au niveau de l'espace vide. L'insertion de ces films a pour effet d'assurer une déformation plus homogène dans toute l'épaisseur des couches, cette épaisseur s'étendant radialement.

On prévoit par exemple de superposer 50 couches entre lesquelles sont disposées des fils enroulés.

A titre d'exemple, la hauteur de l'espace vide est de 3 mm, la hauteur du manchon est de 20 mm et l'épaisseur du manchon est de $250 \mu$m.

Ce dispositif est très efficace, de réalisation plus simple puisque les électrodes peuvent être formées par de simples fils enroulés, et les spires ne s'opposent pas à l'étirement. En outre, les spires maintiennent le diélectrique en forme suivant la direction radiale.

Il est bien entendu que le nombre de couches diélectriques et de fils enroulés peut être quelconque. En outre, la forme tubulaire n'est pas non plus limitative, par exemple le manchon peut avoir une section elliptique. Par ailleurs, les supports 40 et 42 peuvent être liés par un guidage mécanique, une glissière par exemple, assurant un déplacement relatif selon l'axe X des deux manchons. Ces supports peuvent être creux ou autres, seule la surface extérieure importe (forme tubulaire par exemple).

Par exemple, le dispositif des figures 10A et 10B peut être réalisé selon le procédé suivant :

1 - positionnement des supports 40 et 42 à une première distance h1,
2 - enroulement d'une première couche étirable 48 autour des supports 40, 42,
3 - enroulement d'un fil conducteur 50 sur n spires de façon à couvrir l'espace d'entrefer h1,
4 - dépôt d'un électret 10 entre les spires du fil conducteur,
5 - recouvrement par une couche de diélectrique étirable 52,
6 - recouvrement par une électrode étirable pleine, par exemple un polymère conducteur, ou par n spires d'un fil conducteur 54 qui se trouve en quinconce par rapport au fil conducteur 50 de la couche précédente et dont les interstices sont remplis d'un électret 110 de polarité opposé,
7 - recouvrement par une couche de diélectrique étirable 56,
8 - les étapes 3 à 7 sont répétées jusqu'à atteindre le nombre de couches désiré (ou la raideur mécanique désirée),
9- enfin, on précontraint le manchon, en appliquant une contrainte mécanique imposant une distance d'entrefer minimum h2 supérieure à h1 afin d'assurer une tension minimale sur le polymère,

De manière avantageuse, les couches se fixent les unes aux autres par collage.

Le dispositif fonctionne entre la position h2 et une position h3 > h2, le dispositif permettant de convertir ce mouvement relatif en énergie électrique

On peut prévoir, après la mis en place de la première couche étirable 48 et après la mise en place de chaque couche étirable de diélectrique, d'enrouler un film non étirable sur les zones d'encastrement supérieure et inférieure entre le manchon et les supports 40, 42.

Nous allons maintenant décrire un exemple d'un procédé de réalisation d'un système à capacité variable selon la présente invention.

Sur la figure 11, on peut voir un exemple de représentation d'une fabrication d'un système selon la présente invention sous la forme d'une chaîne de fabrication.

On part du diélectrique sous forme de bande enroulée.

Lors d'une étape 100, le diélectrique est mis en forme, par exemple en lui appliquant une précontrainte en étirement de surface, de sorte à créer une force élastique de rappel en son sein facilitant le retour du système à sa forme initiale.

Lors d'une étape 200, on effectue le dépôt de la première électrode 4 ajourée sur une face du diélectrique, par exemple par lithographie.

Lors d'une étape 300, on effectue le dépôt du matériau de base de l'électret 10, ce matériau étant non chargé, par exemple il peut s'agir de téflon ou de parylène, dans les lumières de l'électrode 4, sur toute la surface dans le cas d'un matériau déformable, de type poudre ou polymère élastique, ou sensiblement au centre des lumières dans le cas d'un matériau solide.

Lors d'une étape 400, a lieu la polarisation du matériau de base de l'électret de sorte à former l'électret, cette polarisation étant obtenue par décharge Corona, par vent ionique, par accélération d'électrons ou par accélération d'ions.

Lors d'une étape 500, on retourne le diélectrique et on dépose ensuite la deuxième électrode 8, par exemple par lithographie. La deuxième électrode peut être pleine ou ajourée.

Si on souhaite réaliser un système similaire à celui de la figure 4, on effectue, lors d'une étape 600, le dépôt d'un matériau de base d'un deuxième électret dans les lumières 112 de la deuxième électrode.

Puis, lors d'une étape 700, on effectue la polarisation de ce matériau comme pour le premier électret.

Lors d'une étape 800, on peut effectuer un réajustement de la précontrainte, soit pour augmenter la précontrainte du diélectrique, soit pour assurer une synchronisation des différents éléments du système dans le cas de la réalisation d'un système multicouches du type de celui de la figure 6'. En effet, dans le cas où le système comporte des premier 10 et deuxième 110 électrets, et que l'on veut réaliser un système multicouches par enroulement d'une bande sur elle-même, il faut prévoir de synchroniser les motifs du premier électret avec les motifs des deuxièmes électrodes des couches amont et aval ortho-radialement. Du fait de la superposition des couches, le périmètre de l'enroulement augmente, la bande est donc étirée de sorte à aligner ortho-radialement les motifs. L'alignement ortho-radial est également requis entre les motifs du deuxième électret avec les motifs des premières électrodes des couches amont et aval. Pour obtenir un fonctionnement correct dans une structure multicouche avec deux types d'électrets 10 et 110, il est important, comme présenté figure 6', d'avoir selon l'épaisseur une succession de couches de type 4,6,110,6,4,6,110,6,4,6,110,6,4... alternées/juxtaposées avec des successions de type 10,6,108,6,10,6,108,6,10,6,108,6,10,6,108.... Les électrodes 4 sont alors toujours en face d'électrets de type 110 et à coté d'électrets de type 10 et les électrodes 108 en face d'électrets de type 10 et à coté d'électrets de type 110.

Dans une étape 900, on peut prévoir d'enrouler la bande sur elle-même pour former un système multicouches. On peut prévoir d'insérer un séparateur diélectrique 1000 entre chaque enroulement de la bande.

Cet exemple de procédé présente l'avantage de permettre de réaliser sur les différentes zones de la même bande diélectrique les différentes étapes simultanément, chaque étape étant effectuée successivement sur chaque zone de la bande.

Il est bien entendu que l'ordre des étapes ci-dessus n'est en aucun cas limitatif.

Par ailleurs, un système à capacité variable obtenu par un procédé de réalisation classique, dans lequel on ferait subir la même étape à toute la couche diélectrique ne sort pas du cadre de la présente invention.

## Revendications

1. Système à capacité variable comportant une première électrode (4), une deuxième électrode (8, 108), une couche en matériau diélectrique (6) déformable élastiquement, ladite couche diélectrique (6) étant disposée entre la première (4) et la deuxième électrode (8, 108), un premier électret (10) formant avec la première électrode (4) un premier condensateur (COND1), et le premier électret (10) formant avec la deuxième électrode (8, 108) un deuxième condensateur (COND2), les capacités (C1, C2) des premier (COND1) et deuxième (COND2) condensateur variant avec une déformation de la couche diélectrique (6), la première électrode (4), la deuxième électrode (8, 108) et le premier électret (10) étant tels qu'ils suivent les déformations de la couche diélectrique (6) et qu'une déformation de la couche diélectrique (6) provoque une variation en sens opposé des capacités (C1, C2) du premier (CONd1) et du deuxième (CONd2) condensateur, la première électrode comportant au moins deux portions aptes à se rapprocher et à s'éloigner l'une de l'autre, ledit électret étant disposé entre lesdites deux portions de la première électrode, les bords des portions formant avec le premier électret (10) le premier condensateur (COND1), ledit premier électret (10) étant sur ou dans la couche diélectrique (6).

2. Système à capacité variable selon la revendication 1, dans lequel au moins la première électrode (4) est munie d'au moins une lumière (12) dans laquelle est situé le premier électret (10), le bord de ladite lumière (12) formant avec le premier électret (10) situé dans ladite lumière (12) le premier condensateur (COND1), ledit premier électret (10) étant sur ou dans la couche diélectrique (6).

3. Système à capacité variable selon la revendication 1, ayant une forme cylindrique d'axe longitudinal et dans lequel la première électrode est formée par un fil conducteur électrique enroulé d'axe longitudinal formant une succession de spires, le premier électret étant situé entre deux spires successives.

4. Système à capacité variable selon la revendication 1, 2 ou 3, dans lequel la deuxième électrode (8) est formée par une couche sensiblement pleine et est recouverte de la couche diélectrique (6), la première électrode (4) recouvrant la couche électrique (6) sur une face opposée à celle en contact avec la deuxième électrode (8).

5. Système à capacité variable selon la revendication 3, dans lequel la deuxième électrode est également formée par un fil conducteur électrique enroulé d'axe longitudinal formant une succession de spires, un deuxième électret étant disposé entre au moins deux spires successives, les spires des première et deuxième électrodes étant décalées de sorte que les premier et deuxième électrets ne soient pas alignés selon une direction radiale.

6. Système à capacité variable selon la revendication 2, dans lequel la deuxième électrode (108) comporte également au moins une lumière (112) dans laquelle est disposé un deuxième électret (110) de charge opposée au premier électret (10), de sorte que la deuxième électrode (108) forme avec le deuxième électret (110) un quatrième condensateur (COND4) à capacité variable (C4), et la première électrode (4) forme avec le deuxième électret (110) un cinquième condensateur (COND5) à capacité variable (C5), les capacités (C1, C4) des premier (COND1) et quatrième (COND4) condensateurs variant dans le même sens, et les capacités (C2, C5) des deuxième (CONd2) et cinquième (CONd5) condensateur variant dans le même sens avec la déformation de la couche diélectrique (6).

7. Système à capacité variable selon la revendication 2 à 6, dans lequel le premier (10) et/ ou le deuxième (110) électret est (sont) disposé(s) sensiblement au centre de ladite lumière (12, 112) ou au centre de la zone délimitée par deux spires successives de manière sensiblement ponctuelle.

8. Système à capacité variable selon l'une des revendications 2 à 6, dans lequel le premier (10) électret et/ ou le deuxième (110) électret remplit (remplissent) la lumière (12, 112) et est (sont) en contact avec les bords de ladite lumière (12, 112), ou le premier (10) électret et/ ou le deuxième (110) électret remplit la zone délimitée par les deux spires successives, et est en contact avec lesdites spires.

9. Système à capacité variable selon l'une des revendications précédentes, dans lequel la première et/ou la deuxième électrode(s) a (ont) des structures telles qu'elle(s) est (sont) déformable(s) élastiquement.

10. Système à capacité variable selon la revendication précédente en combinaison avec l'une des revendications 2 ou 6, dans lequel la première électrode (4) et/ ou la deuxième électrode (108) est (sont) formée(s) par un ensemble de barreaux (18) interconnectés de sorte à former un treillis délimitant plusieurs lumières (12, 112), dans chacune desquelles le premier électret (10) et/ou le deuxième (110) électret est (sont) situés.

11. Système à capacité variable selon la revendication 10, dans lequel le treillis est tel qu'une déformation du treillis dans une direction de son plan ne provoque peu ou pas de déformation dans une autre direction contenue dans le plan.

12. Système à capacité variable selon la revendication 10, dans lequel le treillis est tel qu'une déformation du treillis dans une direction de son plan provoque une déformation dans une autre direction contenue dans le plan.

13. Système à capacité variable selon la revendication 12, dans lequel le treillis comporte des rangées de chevrons, deux rangées successives étant décalées d'un demi-pas, de sorte que les chevrons de deux rangées successives dessinent des losanges, des barreaux d'interconnexion reliant les pointes des chevrons de deux rangées successives, ces pointes étant les sommets de losanges ou des barreaux (18) définissant des lumières en forme de nid d'abeille.

**14.** Système à capacité variable selon l'une des revendications 1 à 13, dans lequel la première (4) et la deuxième (8, 108) électrode sont telles que la capacité (C3) du condensateur formé par la première (4) et la deuxième (8, 108) électrode séparées par la couche diélectrique (6) est minimale, la deuxième (8, 108) électrode étant structurée, par exemple celle-ci comportant des lumières, de sorte que les surfaces en regard des première (4) et deuxième (8, 108) électrodes soient réduites.

**15.** Système de conversion d'énergie mécanique en énergie électrique comportant au moins un système selon l'une des revendications précédentes, la conversion de l'énergie mécanique en énergie électrique ayant lieu lors d'une phase de déformation de la couche diélectrique (6) à partir de sa forme initiale et lors de son retour d'une forme déformée à sa forme initiale.

**16.** Système de conversion d'énergie mécanique en énergie électrique selon la revendication précédente, de type interrupteur, destiné à envoyer une commande à un appareil, dans lequel l'énergie électrique produite lors de la première phase de déformation est utilisée pour envoyer la commande à l'appareil, le système de conversion étant ainsi autoalimenté.

**17.** Système de conversion d'énergie mécanique en énergie électrique selon la revendication 15 en combinaison avec la revendication 3 ou 5, dans lequel le système à capacité variable a la forme d'un manchon cylindrique, le ou les fils étant enroulés le long de l'axe du manchon, ledit manchon étant fixé au niveau de ses extrémités axiales à deux éléments aptes à se rapprocher et à s'éloigner l'un de l'autre le long de l'axe du manchon, de sorte qu'un déplacement relatif des deux éléments déforme axialement le manchon.

**18.** Actionneur comportant au moins un système selon l'une des revendications 1 à 14 ou 17 l'application d'une tension entre la première et la deuxième électrode provoquant une déformation dans un plan moyen du système et/ou dans une direction orthogonale au dit plan moyen ou une déformation le long de l'axe longitudinal du manchon.

**19.** Procédé de fabrication d'un système à capacité variable selon la revendication 2 ou 6, comportant les étapes de :

- dépôt de la première électrode (4) sur une face de la couche diélectrique (6), par exemple par lithographie,
- dépôt d'un matériau destiné être polarisé pour former le premier électret (10) dans au moins une lumière (12) de la première électrode (4), par exemple du téflon ou du parylène,
- polarisation dudit matériau,
- dépôt de la deuxième électrode (8, 108) sur l'autre face de la couche diélectrique (6), par exemple par lithographie ou dépôt d'un matériau destiné être polarisé pour former le deuxième électret (110) dans la au moins une lumière de la deuxième électrode (108), par exemple du téflon ou du parylène, e t polarisation dudit matériau.

**20.** Procédé de fabrication selon la revendication 19, comportant l'étape d'application d'une précontrainte en étirement à la couche diélectrique (6), préalable au dépôt de la première électrode (4), et avantageusement l'étape de réajustement de la précontrainte après la polarisation du premier (10) ou du deuxième (110) électret.

**21.** Procédé de fabrication selon l'une des revendications 19 ou 20, dans lequel la couche diélectrique (6) se trouve sous la forme d'une bande dont des zones subissent simultanément les différentes étapes du procédé de fabrication.

**Patentansprüche**

**1.** System mit variabler Kapazität, umfassend eine erste Elektrode (4), eine zweite Elektrode (8, 108), eine Schicht aus elastisch verformbarem dielektrischem Material (6), wobei die dielektrische Schicht (6) zwischen der ersten Elektrode (4) und der zweiten Elektrode (8, 108) angeordnet ist, wobei ein erstes Elektret (10) mit der ersten Elektrode (4) einen ersten Kondensator (COND1) bildet, und wobei das erste Elektret (10) mit der zweiten Elektrode (8, 108) einen zweiten Kondensator (COND2) bildet, wobei die Kapazitäten (C1, C2) des ersten Kondensators (COND1) und des zweiten Kondensators (COND2) bei einer Verformung der dielektrischen Schicht (6) variieren, wobei die erste Elektrode (4), die zweite Elektrode (8, 108) und das erste Elektret (10) derart sind, dass sie den Verformungen der dielektrischen Schicht (6) folgen, und dass eine Verformung der dielektrischen Schicht (6) eine Variation der Kapazitäten (C1, C2) des ersten Kondensators (COND1) und des zweiten Kondensators (COND2) in entgegengesetzter Richtung bewirkt, wobei die erste Elektrode wenigstens zwei Bereiche umfasst, die dazu ausgelegt sind, sich einander anzunähern und voneinander zu entfernen, wobei das Elektret zwischen den zwei Bereichen der ersten Elektrode angeordnet ist, wobei die Ränder der Bereiche mit dem ersten Elektret (10) den ersten Kondensator (COND1) bilden, wobei das erste Elektret (10) auf der oder in der dielektrischen Schicht (6) ist.

2. System mit variabler Kapazität nach Anspruch 1, bei dem wenigstens die erste Elektrode (4) mit wenigstens einer Öffnung (12) ausgestattet ist, in der das erste Elektret (10) angeordnet ist, wobei der Rand der Öffnung (12) mit dem ersten Elektret (10), das in der ersten Öffnung (12) angeordnet ist, den ersten Kondensator (COND1) bildet, wobei das erste Elektret (10) auf der oder in der dielektrischen Schicht (6) ist.

3. System mit variabler Kapazität nach Anspruch 1, das eine zylindrische Form mit einer longitudinalen Achse hat, und bei dem die erste Elektrode durch einen aufgerollten elektrisch leitenden Draht mit longitudinaler Achse gebildet ist, der eine Folge von Wicklungen bildet, wobei das erste Elektret zwischen zwei aufeinanderfolgenden Wicklungen angeordnet ist.

4. System mit variabler Kapazität nach Anspruch 1, 2 oder 3, bei dem die zweite Elektrode (8) durch eine im Wesentlichen volle Schicht gebildet ist und mit der dielektrischen Schicht (6) bedeckt ist, wobei die erste Elektrode (4) die elektrische Schicht (6) auf einer Fläche bedeckt, die entgegengesetzt zu jener in Kontakt mit der zweiten Elektrode (8) ist.

5. System mit variabler Kapazität nach Anspruch 3, bei dem die zweite Elektrode ebenfalls durch einen aufgerollten elektrisch leitenden Draht mit longitudinaler Achse gebildet ist, der eine Folge von Wicklungen bildet, wobei ein zweites Elektret zwischen wenigstens zwei aufeinanderfolgenden Wicklungen angeordnet ist, wobei die Wicklungen der ersten und der zweiten Elektrode derart versetzt sind, dass das erste und das zweite Elektret in einer radialen Richtung nicht ausgerichtet sind.

6. System mit variabler Kapazität nach Anspruch 2, bei dem die zweite Elektrode (108) ebenfalls wenigstens eine Öffnung (112) umfasst, in der ein zweites Elektret (110) mit einer Ladung angeordnet ist, die zum ersten Elektret (10) entgegengesetzt ist, derart, dass die zweite Elektrode (108) mit dem zweiten Elektret (110) einen vierten Kondensator (COND4) mit variabler Kapazität (C4) bildet, und die erste Elektrode (4) mit dem zweiten Elektret (110) einen fünften Kondensator (COND5) mit variabler Kapazität (C5) bildet, wobei die Kapazitäten (C1, C4) des ersten Kondensators (COND1) und des vierten Kondensators (COND4) bei der Verformung der dielektrischen Schicht (6) in der gleichen Richtung variieren, und die Kapazitäten (C2, C5) des zweiten Kondensators (COND2) und des fünften Kondensators (COND5) in der gleichen Richtung variieren.

7. System mit variabler Kapazität nach Anspruch 2 bis 6, bei dem das erste Elektret (10) und/oder das zweite Elektret (110) im Wesentlichen in der Mitte der Öffnung (12, 112) oder in der Mitte der Zone angeordnet ist/sind, die durch zwei aufeinanderfolgende Wicklungen begrenzt ist, und zwar im Wesentlichen punktförmig.

8. System mit variabler Kapazität nach einem der Ansprüche 2 bis 6, bei dem das erste Elektret (10) und/oder das zweite Elektret (110) die Öffnung (12, 112) füllt/füllen und in Kontakt mit den Rändern der Öffnung (12, 112) ist/sind, oder das erste Elektret (10) und/oder das zweite Elektret (110) die Zone füllt, die durch zwei aufeinander folgende Wicklungen begrenzt ist, und in Kontakt mit den Wicklungen ist.

9. System mit variabler Kapazität nach einem der vorhergehenden Ansprüche, bei dem die erste und/oder die zweite Elektrode eine Struktur derart hat/haben, dass sie elastisch verformbar ist/sind.

10. System mit variabler Kapazität nach dem vorhergehenden Anspruch in Kombination mit einem der Ansprüche 2 oder 6, bei dem die erste Elektrode (4) und/oder die zweite Elektrode (108) durch eine Gruppe von Stäben (18) gebildet ist/sind, die derart miteinander verbunden sind, dass sie ein Geflecht bilden, das mehrere Öffnungen (12, 112) begrenzt, in jeder von denen das erste Elektret (10) und/oder das zweite Elektret (110) angeordnet ist/sind.

11. System mit variabler Kapazität nach Anspruch 10, bei dem das Geflecht derart gebildet ist, dass eine Verformung des Geflechts in einer Richtung seiner Ebene keine oder wenig Verformung in einer anderen Richtung bewirkt, die in der Ebene enthalten ist.

12. System mit variabler Kapazität nach Anspruch 10, bei dem das Geflecht derart gebildet ist, dass eine Verformung des Geflechts in einer Richtung seiner Ebene eine Verformung in einer anderen Richtung bewirkt, die in der Ebene enthalten ist.

13. System mit variabler Kapazität nach Anspruch 12, bei dem das Geflecht Zickzackreihen umfasst, wobei zwei aufeinanderfolgende Reihen um einen halben Schritt versetzt sind, derart, dass die Zickzackmuster von zwei aufeinander folgenden Reihen Rauten darstellen, wobei Verbindungsstangen die Spitzen der Zickzackmuster von zwei aufeinander folgenden Reihen verbinden, wobei diese Spitzen die Gipfel von Rauten oder Stangen (18) sind, die Öffnungen in Bienenwabenform definieren.

14. System mit variabler Kapazität nach einem der Ansprüche 1 bis 13, bei dem die erste Elektrode (4) und die zweite Elektrode (8, 108) derart gebildet sind, dass die Kapazität (C3) des Kondensators, der durch die erste Elektrode (4) und die zweite Elektrode (8, 108) gebildet ist, welche durch die dielektrische Schicht (6) separiert sind, minimal ist, wobei die zweite Elektrode (8, 108) strukturiert ist, wobei diese beispielsweise Öffnungen umfasst, derart, dass die gegenüberliegenden Oberflächen der ersten Elektrode (4) und der zweiten Elektrode (8, 108) reduziert sind.

15. System zur Konversion mechanischer Energie in elektrische Energie, umfassend wenigstens ein System nach einem der vorhergehenden Ansprüche, wobei die Konversion der mechanischen Energie in elektrische Energie während einer Phase der Verformung der dielektrischen Schicht (6) ausgehend von ihrer anfänglichen Form und während ihrer Rückkehr von einer verformten Form in ihre anfängliche Form erfolgt.

16. System zur Konversion mechanischer Energie in elektrische Energie nach dem vorhergehenden Anspruch vom Typ Unterbrecher, das dazu ausgelegt ist, einen Befehl an ein Gerät zu schicken, wobei die elektrische Energie, die während der ersten Verformungsphase erzeugt wird, dazu verwendet wird, den Befehl an das Gerät zu schicken, wobei das Konversionssystem somit selbstversorgt ist.

17. System zur Konversion mechanischer Energie in elektrische Energie nach Anspruch 15 in Kombination mit Anspruch 3 oder 5, bei dem das System mit variabler Kapazität die Form einer zylindrischen Muffe hat, wobei der Draht oder die Drähte entlang der Achse der Muffe aufgerollt ist/sind, wobei die Muffe auf Höhe ihrer axialen Enden an zwei Elementen befestigt ist, die dazu ausgelegt sind, sich entlang der Achse der Muffe einander anzunähern und voneinander zu entfernen, derart, dass eine Relativverlagerung der zwei Elemente die Muffe axial verformt.

18. Betätigungselement, umfassend wenigstens ein System nach einem der Ansprüche 1 bis 14 oder 17, wobei das Anlegen einer Spannung zwischen der ersten und der zweiten Elektrode eine Verformung in einer mittleren Ebene des Systems und/oder in einer Richtung orthogonal zu der mittleren Ebene bewirkt, oder eine Verformung entlang der longitudinalen Achse der Muffe.

19. Verfahren zur Herstellung eines Systems mit variabler Kapazität nach Anspruch 2 oder 6, umfassend die folgenden Schritte:

   - Aufbringen der ersten Elektrode (4) auf einer Fläche der dielektrischen Schicht (6), beispielsweise durch Lithographie,
   - Aufbringen eines Materials, das dazu ausgelegt ist, polarisiert zu werden, um das erste Elektret (10) zu bilden, in wenigstens einer Öffnung (12) der ersten Elektrode (4), beispielsweise Teflon oder Parylen,
   - Polarisieren des Materials,
   - Aufbringen der zweiten Elektrode (8, 108) auf der anderen Fläche der dielektrischen Schicht (6), beispielsweise durch Lithographie oder Aufbringen eines Materials, das dazu ausgelegt ist, polarisiert zu werden, um das zweite Elektret (110) zu bilden, in der wenigstens einen Öffnung der zweiten Elektrode (108), beispielsweise Teflon oder Parylen, und Polarisieren des Materials.

20. Verfahren zur Herstellung nach Anspruch 19, umfassend den Schritt des Ausübens einer Streck-Vorspannung auf die dielektrische Schicht (6) vor der Aufbringung der ersten Elektrode (4), und vorzugsweise den Schritt der Anpassung der Vorspannung nach dem Polarisieren des ersten Elektrets (10) oder des zweiten Elektrets (110).

21. Verfahren zur Herstellung nach einem der Ansprüche 19 oder 20, bei dem die dielektrische Schicht (6) in Form eines Bands vorliegt, dessen Zonen gleichzeitig die verschiedenen Schritte des Herstellungsverfahrens durchlaufen.

**Claims**

1. Variable capacitance system comprising a first electrode (4), a second electrode (8, 108), a layer of elastically deformable dielectric material (6), wherein said dielectric layer (6) is positioned between the first (4) and the second electrode (8, 108), wherein a first electret (10) forms with the first electrode (4) a first capacitor (COND1), and the first electret (10) forms with the second electrode (8, 108) a second capacitor (COND2), and the capacitances (C1, C2) of the first (COND1) and second (COND2) capacitor vary with a deformation of the dielectric layer (6), and the first electrode (4), the second electrode (8, 108) and the first electret (10) are such that as they follow the deformations of the dielectric layer (6) and that a deformation of the dielectric layer (6) causes an inverse variation of the capacitances (C1, C2) of the first (CONd1) and of the second (CONd2) capacitor, the first electrode comprising at least two portions that may move closer together or further away from one another, said electret is positioned between said two portions of the first electrode, wherein the edges of the portions form with the first electret (10) the first capacitor (COND1), and said first electret (10) is on or in the dielectric layer (6).

2. Variable capacitance system according to claim 1, in which at least the first electrode (4) is equipped with at least one slot (12) in which the first electret (10) is located, wherein the edge of said slot (12) forms with the first electret (10) located in said slot (12) the first capacitor (COND1), and said first electret (10) is on or in the dielectric layer (6).

3. Variable capacitance system according to claim 1, which has a cylindrical form with a longitudinal axis and in which the first electrode is formed by a wound electrically conductive wire with a longitudinal axis forming a succession of turns, wherein the first electret is located between two successive turns.

4. Variable capacitance system according to claims 1, 2 or 3, in which the second electrode (8) is formed by a substantially solid layer and is covered by the dielectric layer (6), wherein the first electrode (4) covers the electric layer (6) on a face opposite to that in contact with the second electrode (8).

5. Variable capacitance system according to claim 3, in which the second electrode is also formed by a wound electrically conductive wire with a longitudinal axis forming a succession of turns, wherein a second electret is located between at least two successive turns, and the turns of the first and second electrodes are offset so that the first and second electrets are not aligned according to a radial direction.

6. Variable capacitance system according to claim 2, in which the second electrode (108) also comprises at least one slot (112) in which a second electret (110) is located with a charge opposed to that of the first electret (10), so that the second electrode (108) forms with the second electret (110) a fourth capacitor (COND4) of variable capacitance (C4), and the first electrode (4) forms with the second electret (110) a fifth capacitor (COND5) of variable capacitance (C5), wherein the capacitances (C1, C4) of the first (COND1) and fourth (COND4) capacitors vary in the same direction, and the capacitances (C2, C5) of the second (CONd2) and fifth (CONd5) capacitor vary in the same direction as the deformation of the dielectric layer (6).

7. Variable capacitance system according to claims 2 to 6, in which the first (10) and/or the second (110) electret is (are) substantially located in the centre of said slot (12, 112) or in the centre of the zone defined by two successive turns substantially punctually

8. Variable capacitance system according to any of claims 2 to 6, in which the first (10) electret and/or the second (110) electret fill(s) the slot (12, 112) and is (are) in contact with the edges of said slot (12, 112), or the first (10) electret and/or the second (110) electret fills the zone defined by the two successive turns, and is in contact with said turns.

9. Variable capacitance system according to any of the previous claims, in which the first and/or the second electrode(s) has (have) structures such that it(they) is (are) elastically deformable.

10. Variable capacitance system according to the previous claim combined with any of claims 2 or 6, in which the first electrode (4) and/or the second electrode (108) is (are) formed by a set of interconnected bars (18) such that they form a lattice defining several slots (12, 112), inside each of which the first electret (10) and/or the second (110) electret is (are) located.

11. Variable capacitance system according to claim 10, in which the lattice is such that a deformation of the lattice in one direction of its plane does not cause or hardly causes deformation in another direction contained in the plane.

12. Variable capacitance system according to claim 10, in which the lattice is such that a deformation of the lattice in one direction of its plane causes a deformation in another direction contained in the plane.

**13.** Variable capacitance system according to claim 12, in which the lattice has rows of zigzag patterns, wherein two successive rows are offset by a half pitch, such that the zigzag patterns of two successive rows form rhomb shapes, and interconnection bars connect the points of the zigzag patterns of two successive rows, and these points are the summits of the rhombs.

**14.** Variable capacitance system according to any of claims 1 to 13, in which the first (4) and the second (8, 108) electrode are such that the capacitance (C3) of the capacitor formed by the first (4) and the second (8, 108) electrode separated by the dielectric layer (6) is minimal, the second (8, 108) electrode being structured, for example it has slots, such that the surfaces opposite the first (4) and second (8, 108) electrodes are reduced.

**15.** System for converting mechanical energy into electrical energy comprising at least one system according to any of the previous claims, wherein the conversion of the mechanical energy into electrical energy takes place during a deformation phase of the dielectric layer (6) from its initial form and during its return from a deformed form to its initial form.

**16.** System for converting mechanical energy into electrical energy according to the previous claim, of the switch type, designed to send a command to an appliance, in which the electrical energy produced during the first deformation phase is used to send the command to the appliance, and the conversion system is thus self-powered.

**17.** System for converting mechanical energy into electrical energy according to claim 15 combined with claims 3 or 5, in which the variable capacitance system has the form of a cylindrical sleeve, wherein the wire(s) is/are wound along the axis of the sleeve, wherein said sleeve is fixed at its axial ends which have two elements that may move closer together or further away from one another along the axis of the sleeve, such that a relative movement of the two elements deforms the sleeve axially.

**18.** Actuator comprising at least one system according to any of claims 1 to 14 or 17, wherein the application of a voltage between the first and the second electrode causes a deformation in a mean plane of the system and/or in a direction that is orthogonal to said mean plane or a deformation along the longitudinal axis of the sleeve.

**19.** Manufacturing method for a variable capacitance system according to claims 2 or 6, comprising the steps of:

- depositing the first electrode (4) onto a face of the dielectric layer (6), for example by lithography,
- depositing a material designed to be polarised to form the first electret (10) in at least one opening (12) of the first electrode (4), for example Teflon or parylene,
- polarising of said material,
- depositing the second electrode (8, 108) on the other face of the dielectric layer (6), for example by lithography or depositing of a material configured to be polarised to form a second electret (110) in the at least one opening of the second electrode (108), for example Teflon or parylene, and polarising said material.

**20.** Manufacturing method according to claim 19, comprising the step of applying an elongation preload to the dielectric layer (6), prior to depositing the first electrode (4), and advantageously the step of adjusting the preload after polarising the first (10) or the second (110) electret.

**21.** Manufacturing method according to claim 19 or 20, in which the dielectric layer (6) is in the form of a strip whose zones undergo simultaneously the different steps of the manufacturing method.

FIG. 1

FIG. 1'

FIG. 1"

FIG. 2

FIG. 5

EP 2 340 545 B1

FIG. 3A

FIG. 3B

FIG. 3C

FIG. 3D

FIG. 3E

FIG. 4

# FIG. 6

# FIG. 6'

FIG. 7

FIG. 8A

FIG. 8B

FIG. 9

FIG. 11

FIG. 10A

FIG. 10B

## RÉFÉRENCES CITÉES DANS LA DESCRIPTION

**Documents brevets cités dans la description**

- WO 0167810 A

**Littérature non-brevet citée dans la description**

- **CLAIRE JEAN-MISTRAL ; SKANDAR BASROUR ; JEAN-JACQUES CHAILLOUT.** Dielectric polymer: scavenging energy from human motion. *Electroactive Polymer Actuators and Devices,* 2008, vol. 6927, 692716-1, 692716-10
- Efficiency Evaluation of Micro Seismic Electret Power Generator. **T. TSUTSUMINO ; Y. SUZUKI ; N. KASAGI ; K. KASHIWAGI ; Y. MORIZAWA.** Proceedings of the 23rd Sensor Symposium. Takamatsu, 2006, 521-524
- An Electret-based Electrostatic $\mu$-generator. **T. STERKEN ; P. FIORINI ; K. BAERT ; R. PUERS ; G. BORGHS.** TRANSDUCERS '03, The 12th International Conference on Solid State Sensors, Actuators and Microsystems. IEEE, 08 Juin 2003, vol. 1291, 1291-1294
- **T. STERKEN ; P. FIORINI ; G. ALTENA ; C. VAN HOOF ; R. PUERS.** Harvesting Energy from Vibrations by a Micormachined Electret Generator. IEEE, 129-132
- Electroactive Polymer Actuators and Devices. 2008, vol. 6927
- Parylene HT based electret rotor generator. *MEMS,* 13 Janvier 2008, 984-987